# EUROPEAN PATENT SPECIFICATION

(11) **EP 3 405 014 B1**
(45) Date of publication and mention of the grant of the patent: **14.07.2021**
(21) Application number: 18172595.3
(22) Date of filing: 16.05.2018
(51) Int. Cl.: H05K 7/20

(54) **HOT AISLE MODULES AND CONTAINMENT SYSTEMS**
WARMGANGMODULE UND EINHAUSUNGSSYSTEME
MODULES D'ALLÉE CHAUDE ET SYSTÈMES DE CONFINEMENT

(30) Priority: 16.05.2017 US 201715596571
(43) Date of publication of application: 21.11.2018
(73) Proprietor: Tate Access Floors, Inc., Jessup, MD 20794 (US)
(72) Inventor: CURTIN, Daniel J., Jessup, MD 20794 (US); KENNEDY, Daniel, Jessup, MD Maryland 20794 (US); MORRISON, Rachel, Jessup, MD Maryland 20794 (US)
(74) Representative: Schaad, Balass, Menzl & Partner AG

(56) References cited:
- DE-B3-102008 024 973
- US-A1- 2013 160 271
- US-A1- 2017 127 569
- US-B1- 9 622 389

## Description

### BACKGROUND

### 1. Field of the Invention

This invention relates to cooling systems for data centers and other IT or computer facilities. In particular, this invention relates to containment systems for hot aisles in such data centers and other IT or computer facilities and to modules for such containment systems, with the hot aisles being the aisles between adjacent but spaced rows of IT racks and/or cabinets in the data centers and other IT or computer facilities that receive "hot air," which is cooling air after it has passed through and by equipment and accessories in and on the IT racks and cabinets.

### 2. Background of the Invention

A typical IT or computer facility, such as a data center, includes spaced rows of IT racks and/or cabinets. A multitude of computer and other IT equipment and accessories are located in and on those racks and cabinets.

The operation of that equipment and those accessories generates heat. Because of the density of computer and other IT equipment and accessories in and on IT racks and cabinets, the heat generated by the operation of that equipment and those accessories may damage that equipment and those accessories if sufficient cooling air is not provided to the IT racks and cabinets during operation of that equipment and those accessories.

Accordingly, providing adequate cooling air to IT racks and cabinets in IT or computer facilities is of paramount importance. Moreover, it is desirable that the IT racks and cabinets be cooled as efficiently as possible, as the energy costs to cool the IT racks and cabinets may approach a large percentage of the energy costs to operate the IT or computer facility.

Typically, the spaced rows of IT racks and/or cabinets in an IT or computer facility are cooled as follows. The aisles between the rows of IT racks and/or cabinets alternate between "cold aisles," which receive cooling air from the facility's cooling air generator, and "hot aisles," which receive cooling air after it has passed through the rows of IT racks and/or cabinets between the adjacent cold aisles and hot aisles. Stated differently, on one side of each row of IT racks and/or cabinets is a cold aisle, which receives cooling air from the facility's cooling air generator. The cooling air then goes from each cold aisle into and through the two rows of IT racks and/or cabinets forming the cold aisle. The cooling air, after cooling the computer and other IT equipment and accessories in and on the rows of IT racks and/or cabinets, exits out the other side of the IT racks and/or cabinets, *i.e.,* the side opposite the cold aisle. That cooling air, which is now "hot air" because it has been heated by the computer and other IT equipment and accessories in and on the IT racks and cabinets, exits the IT racks and/or cabinets into a hot aisle.

It is desirous to exhaust the hot air from the hot aisles of an IT or computer facility to the vents of the air return system of the facility as directly as possible without intermingling with the cooling air, because any intermingling between the cooling air and the hot air will reduce the overall efficiency of the facility's cooling system, as cooling air would be "wasted" on cooling hot air, instead of cooling the computer and other IT equipment and accessories in and on the rows of IT racks and/or cabinets.

To minimize the intermingling of hot air and cooling air in IT or computer facilities having spaced rows of IT racks and/or cabinets with alternating cold and hot aisles between them, hot aisle containment systems have been developed to at least partially direct the hot air from the hot aisles, to a facility vent or exhaust system.

However, current hot aisle containment systems and the modules for those systems have many problems, including that they must be constructed on site and have limited effectiveness. As to the former problem, the need to construct such systems and modules on site may unduly delay construction of the IT or computer facility and may also interfere or cause problems with other trades working to construct the facility.

DE 10 2008 024 973 B3 discloses an enclosure for a hot aisle of an IT or computer facility, which isolates the room above the hot aisle and extends from an upper edge of cabinets or doors or a rear wall of the hot aisle up to a ceiling construction, in particular an intermediate ceiling. In order to provide a particularly simple enclosure for cabinets and false ceilings of different heights, which is designed for an easy and a time-saving one-man installation, the enclosure has multi-part, preferably two-part vertical profiles and bulkhead plates, which are adjustable in height and telescopically extendable and form an almost jointless facing.

US 2017/0127569 (A1) discloses an air duct system configured to be used with an air containment system that spans an aisle defined by rows of racks of an IT or computer facility. In one embodiment, the air duct system includes a plurality of ceiling panels supported by the air containment system, and a plurality of support curbs mounted on the ceiling panels. The plurality of support curbs is configured to support ductwork positioned on the plurality of support curbs. The air duct system further includes a plurality of panels secured to the support curbs to create a plenum underneath the ductwork. A kit providing an air duct system is further disclosed. The air duct system is designed to facilitate the conveyance of cooling, electrical, and communication/networking equipment.

US 9,622,389 (B1) discloses an integrated data center that provides for efficient cooling, as well as efficient wire routing. A configuration is disclosed in which the data center has an interior frame structure in which an array of electronic equipment cabinet clusters are arranged. The interior frame structure includes support frames for supporting a hot air containment chamber associated with each electronic equipment cabinet cluster and towards which hot air exhaust from the electronic equipment is directed. The interior frame structure further includes various support racks and conduits, by means of which hot air is exhausted, as well as cold air ducts, by means of which cool air is provided to the electronic equipment cabinets. Electronic equipment cabinets can be arranged in rows in the interior frame structure where the cabinets may be rolled in and out of place as required, as well as around load-bearing posts of the interior frame structure, without interference by wiring and other components of the interior frame structure. The equipment cabinets are independent of and not structurally a part of the interior frame structure.

US 2013/0160271 (A1) discloses a hot/cold aisle air containment system which includes a frame structure, at least one electronic equipment enclosure installed at least partially within the frame structure, and a header panel assembly. The frame structure is adapted to be at least partially covered by one or more panels to define an interior space and includes at least one horizontal member. The header panel assembly is installed between a top of the at least one electronic equipment enclosure and the at least one horizontal member of the frame structure to prevent circulation of air above the enclosure. The header panel assembly includes a pair of panels. A first of the pair of panels is adjustable horizontally relative to a second of the pair of panels, and the pair of panels, together, are adjustable vertically relative to the least one horizontal member.

### SUMMARY OF THE INVENTION

In view of the above, it is desirable to provide an effective hot aisle containment system and modules for that system that can be largely constructed off site, readily transported to the job site, and quickly installed in the desired location to minimize any delays in construction of the IT or computer facility due to the construction and installation of the hot aisle containment system and to avoid or minimize interference between the construction and installation of the hot aisle containment system and other construction activities at the job site.

This invention addresses that need, and other needs that will become apparent to those skilled in the art given this disclosure.

A hot aisle module according to one embodiment of this invention may include (1) a chute that forms an air passageway enclosure with an open top and an open bottom and (2) telescopable legs, wherein the chute may be supported by the telescopable legs such that the height of the chute can be adjusted as desired to direct air from a hot aisle of an IT or computer facility to the exhaust system of that facility.

In the hot aisle module of another embodiment of this invention, the chute may be formed by spaced side walls and spaced end walls that are connected at their ends to form an open ended box.

In the hot aisle module of yet another embodiment of this invention, the module may include side arms that are attached to the telescopable legs, with the side arms having a first position in which the side arms do not protrude from the chute and a second position in which the side arms protrude from the chute. The side arms may be substantially parallel to the telescopable legs when in the first position and at an angle other than 0° or 180° with the telescopable legs when in the second position. Also, the side arms may be pivotably attached to the telescopable legs. The side arms may be designed to support cable trays, bus bars and other service items when in the second position.

In the hot aisle module of a further embodiment of this invention, the spaced side walls may be first and second side walls that are substantially parallel and the spaced end walls may be first and second end walls that are substantially parallel, with each of the first and second end walls being connected on its ends to the first and second side walls.

The hot aisle containment system of one embodiment of this invention may include a plurality of hot aisle modules located in spaced hot aisles of an IT or computer facility and support members that extend between and are connected to adjacent ones of the plurality of hot aisle modules. The hot aisle modules may include a chute formed of spaced side walls and spaced end walls, with the spaced side walls and spaced end walls being connected to form an air passageway enclosure with an open top and an open bottom, and telescopable legs. The chute may be supported by the telescopable legs such that the height of the chute can be adjusted to direct air from the hot aisles of an IT or computer facility to an air exhaust system of that facility.

In the hot aisle containment system of another embodiment of this invention, the hot aisles modules are substantially parallel.

In the hot aisle containment system of yet another embodiment, the support members are girders attached at their ends to the telescopable legs of adjacent ones of the plurality of hot aisle modules.

A data center of one embodiment of this invention may include spaced rows of IT racks and/or cabinets, cold and hot aisles between the spaced rows of IT racks and/or cabinets, with the cold aisles and the hot aisles alternating between the spaced rows of IT racks and/or cabinets, and a hot aisle containment system that may include a hot aisle module in two or more hot aisles and support members that extend between and are connected to the hot aisle modules in adjacent hot aisles. The hot aisle modules may include (1) a chute formed of spaced side walls and spaced end walls, with the spaced side walls and spaced end walls being connected to form an air passageway enclosure having an open top and an open bottom, and (2) telescopable legs, wherein the chute is supported by the telescopable legs such that the height of the chute can be adjusted. The chutes may direct air from the hot aisles to an air exhaust system of the data center.

A cooling system for two rows of IT racks and/or cabinets according to one embodiment of this invention may include a hot aisle between the two rows of IT racks and/or cabinets that receives hot air exiting from the two rows of IT racks and/or cabinets and a hot aisle module in the hot aisle. The hot aisle module may include (1) a chute formed of spaced side walls and spaced end walls, with the spaced side walls and spaced end walls being connected to form an air passageway enclosure having an open top and an open bottom, and (2) telescopable legs, wherein the chute is supported by the telescopable legs such that the height of the chute can be adjusted so that the bottom of the chute is positioned above the two rows of IT racks and/or cabinets. The chute may extend between the top of the two rows of IT racks and/or cabinets and an air exhaust system.

This invention also includes a method of installing a hot aisle containment system in an IT or computer facility having spaced rows of IT racks and/or cabinets and alternating hot and cold aisles between the spaced rows of IT racks and/or cabinets. That method may begin with the step of transporting at least two hot aisle modules into the IT or computer facility, with each hot aisle module including (1) a chute formed of spaced side walls and spaced end walls, wherein the spaced side walls and spaced end walls may be connected to form an air passageway enclosure with an open top and an open bottom, and (2) telescopable legs with retracted and extended positions, wherein the chute is supported by the telescopable legs. During at least a portion of that transporting step, the telescopable legs may be in their retracted positions. The method further includes the steps of positioning at least two of the hot aisle modules in at least two of the hot aisles of the IT or computer facility, extending the telescopable legs of the hot aisle modules until the bottoms of their chutes are above the adjacent rows of IT racks and/or cabinets, and connecting the hot aisle modules with support members that extend between and are connected to the hot aisle modules.

### BRIEF DESCRIPTION OF THE FIGURES

Figure 1 is a top perspective view of one embodiment of a hot aisle module of this invention, showing the module with all of its legs in their most retracted positions and all of its foldable side arms in their down or folded positions.
Figure 2 is a top perspective view of the hot aisle module illustrated in Figure 1, showing the module with all of its legs in expanded or extended positions and all of its foldable side arms in their down or folded positions.
Figure 3 is a top perspective view of the hot aisle module illustrated in Figures 1 and 2, showing the module with all of its legs in expanded or extended positions, three of its sets of foldable side arms in their down or folded positions, and one of its sets of foldable side arms being rotated from their down or folded positions to their up or open positions.
Figure 4 is a top perspective view of the hot aisle module illustrated in Figures 1-3, showing the module with all of its legs in expanded or extended positions, two of its sets of foldable side arms in their down or folded positions, one of its sets of foldable side arms in their up or open positions, and one of its sets of foldable side arms being rotated from their down or folded positions to their up or open position.
Figure 5 is a top perspective view of the hot aisle module illustrated in Figures 1-4, showing the module with all of its legs in expanded or extended positions, two of its sets of foldable side arms in their up or open positions, one of its sets of foldable side arms in their down or folded positions, and one of its sets of foldable side arms being rotated from their down or folded positions to their up or open positions.
Figure 6 is a top perspective view of the hot aisle module illustrated in Figures 1-5, showing the module with all of its legs in expanded or extended positions, three of its sets of foldable side arms in their up or open positions, and one of its sets of foldable side arms being rotated from their down or folded positions to their up or open positions.
Figure 7 is a top perspective view of the hot aisle module illustrated in Figures 1-6, showing the module with all of its legs in expanded or extended positions and all its foldable side arms in their up or open positions.
Figure 8 is a top perspective view of one embodiment of an IT or computer facility hot aisle containment system of this invention that includes a plurality of the hot aisle module illustrated in Figures 1-7.
Figure 9 is a partial, side perspective view of another embodiment of a hot aisle containment system of this invention, showing hot aisle door assemblies attached to and supported by a module of the system.
Figure 10 is a schematic plan view of a portion of a typical data center having rows of IT racks and cabinets.
Figure 11 is a schematic plan view of a portion of the hot aisle containment system illustrated in Figure 9 installed in the portion of a typical data center illustrated in Figure 10.
Figure 12 is a partial, side perspective view of a leg of the hot aisle module illustrated in Figures 1-7.
Figure 13 is another partial, side perspective view of the leg illustrated in Figure 12.
Figure 14 is a partial, side perspective view of the hot aisle module illustrated in Figures 1-7, showing the connection of two of the foldable side arms to a leg of the module.
Figure 15 is a schematic showing the movement of the foldable side arms in Figure 14 from their down or folded positions to their up or open positions.
Figure 16 is a partial, side perspective view of a portion of a hot aisle module according to this invention, showing one manner for attaching panels of the module to the supporting framework of the module.
Figure 17 is a partial, side perspective view of a portion of a hot aisle module according to this invention, showing a second manner for attaching panels of the module to the supporting framework of the module.
Figure 18 is a partial, side perspective view of a portion of a hot aisle module according to this invention, showing a third manner of attaching panels of the module to the supporting framework of the module.

### DETAILED DESCRIPTION OF THE EMBODIMENTS ILLUSTRATED BY THE FIGURES

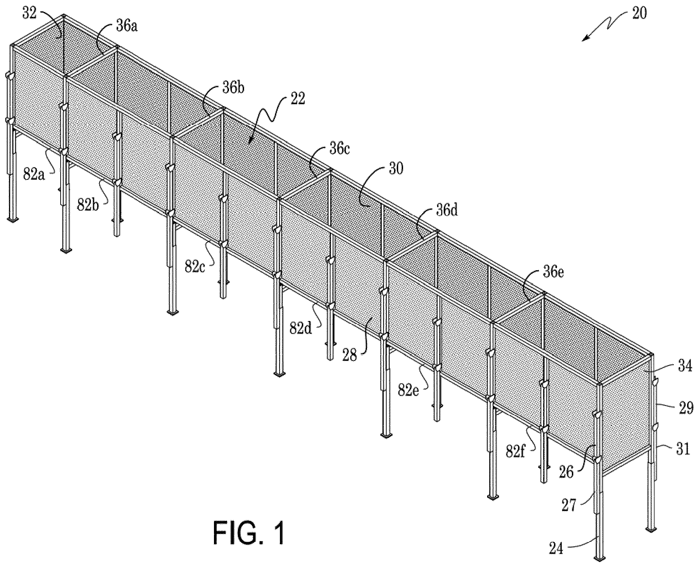

As stated, a hot aisle module of one embodiment of this invention is illustrated in Figures 1-7, hot aisle module 20. Hot aisle module 20 is for use in a data center or other IT or computer facility, as explained below. Hot aisle module 20 has three basic components: chute 22; set 24 of legs 24a-24n (the upper portions of which define, in part, chute 22, as discussed below); and sets 26, 27, 29 and 31 of foldable side arms 26a-261, 27a-271, 29a-29l, and 31a-31l, respectively.

Chute 22 includes side walls 28 and 30 and end walls 32 and 34. *See* Figure 1. Chute 22 has an open top and an open bottom. While chute 22 has a rectangular shape in cross section, with side walls 28 and 30 being substantially parallel and end walls 32 and 34 being substantially parallel, the chutes of the hot aisle modules of other embodiments of this invention may have a different shape in cross section.

As explained in detail below, in use, chute 22 functions as an air passageway enclosure.

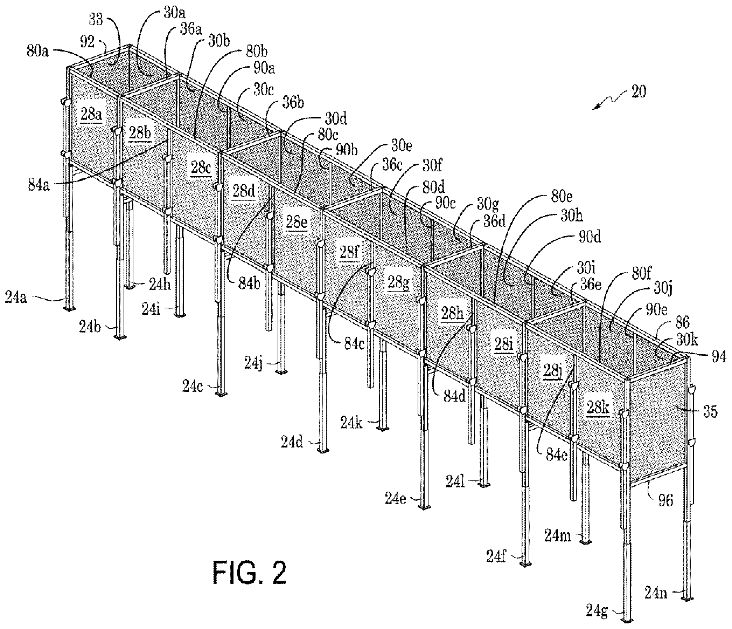

In the hot aisle module of the embodiment of this invention illustrated in Figures 1-7, side wall 28 of chute 22 includes a series of panels 28a-28k, the upper portions of legs 24a-24g and panel framework. *See* Figure 2. Panels 28a-28k are (1) supported and retained by the upper portions of legs 24a-24g and the panel framework and (2) arranged in a row edge-to-edge. While in the hot aisle module of this embodiment of the invention, side wall 28 includes panels 28a-28k, any number of panels can be used to form the side walls of the hot aisle modules of other embodiments of this invention, including a single panel.

Panels 28a-28k can be made of any material that is structurally sound, blocks air and is sufficiently heat resistant. Possible materials for panels 28a-28k include sheet metal and polycarbonate. It is desirable that the material be as lightweight as possible, for ease of, and to minimize the cost of, the shipping and handling of hot aisle modules 20.

The panel framework that supports and retains panels 28a-28k includes top longitudinal supports 80a-80f, bottom longitudinal supports 82a-82f, and vertical supports 84a-84e. *See* Figures 1 and 2. The side walls of hot aisle modules of other embodiments of this invention may have only some or none of those panel supports and retaining members, or other panel supporting and retention means.

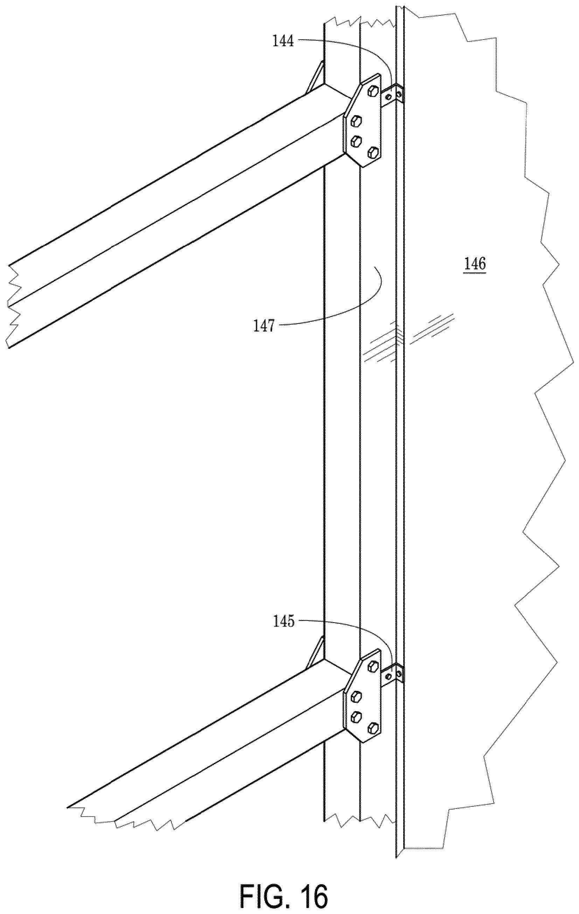

Panels 28a-28k can be attached to legs 24a-24g, top longitudinal supports 80a-80f, bottom longitudinal supports 82a-82f, and vertical supports 84a-84e by any of the known mechanisms, fasteners and manners of attaching flat panels to structural support members. Three such mechanisms, fasteners and manners are illustrated in Figures 16-18.

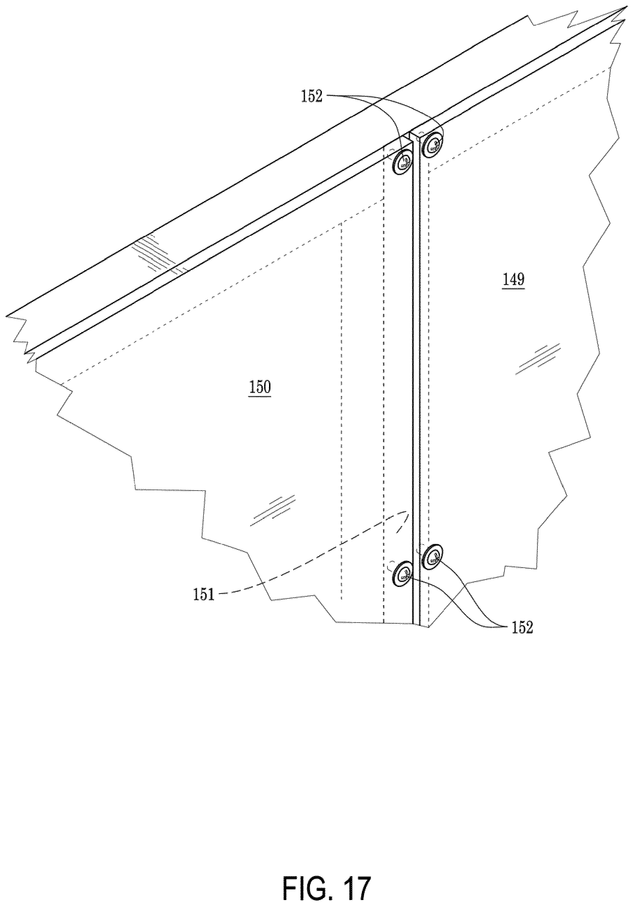

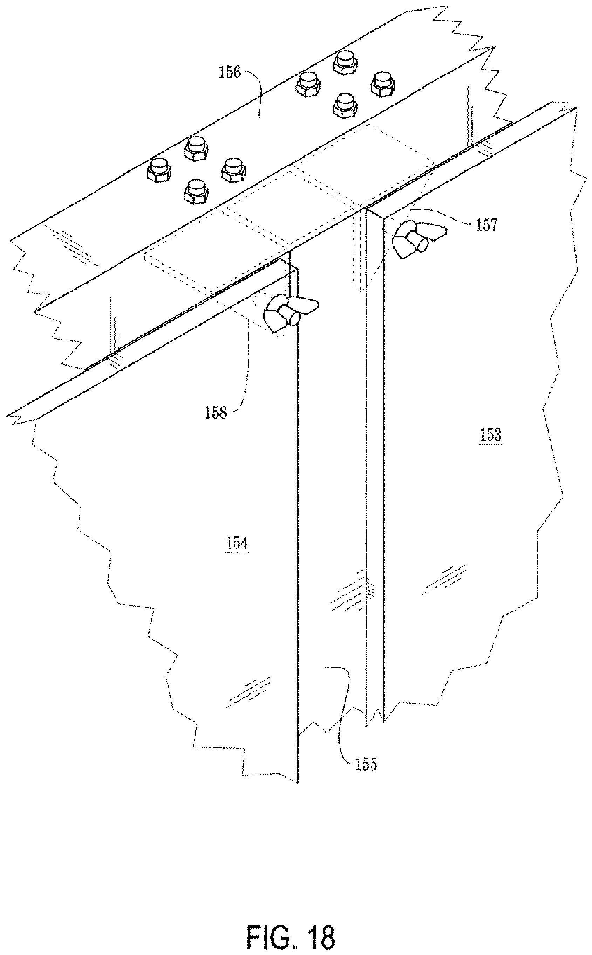

In Figure 16, brackets 144 and 145 are attached to panel 146 and leg 147 to affix panel 146 to leg 147. In Figure 17, panels 149 and 150 are attached to leg 151 by screws 152. In Figure 18, panels 152 and 153 are affixed to leg 155 and top longitudinal support 156 by gusset bracket assemblies 157 and 158, respectively.

In the hot aisle module of this embodiment of the invention, top longitudinal support 80a and bottom longitudinal support 82a extend between and are connected at their ends to legs 24a and 24b, top longitudinal support 80b and bottom longitudinal support 82b extend between and are connected at their ends to legs 24b and 24c, top longitudinal support 80c and bottom longitudinal support 82c extend between and are connected at their ends to legs 24c and 24d, top longitudinal support 80d and bottom longitudinal support 82d extend between and are connected at their ends to legs 24d and 24e, top longitudinal support 80e and bottom longitudinal support 82e extend between and are connected at their ends to legs 24e and 24f, and top longitudinal support 80f and bottom longitudinal support 82f extend between and are connected at their ends to legs 24f and 24g. In the hot aisle modules of other embodiments of this invention, one or both of the sets of top longitudinal supports and bottom longitudinal supports can be an integral, one-piece member.

Vertical supports 84a-84e extend between and are connected at their ends to top longitudinal supports 80b-80f and bottom longitudinal supports 82b-82f, respectively. *See* Figures 1 and 2. Specifically, vertical support 84a extends between and is connected at its ends to top longitudinal support 80b and bottom longitudinal support 82b, vertical support 84b extends between and is connected at its ends to top longitudinal support 80c and bottom longitudinal support 82c, vertical support 84c extends between and is connected at its ends to top longitudinal support 80d and bottom longitudinal support 82d, vertical support 84d extends between and is connected at its ends to top longitudinal support 80e and bottom longitudinal support 82e, and vertical support 84e extends between and is connected at its ends to top longitudinal support 80f and bottom longitudinal support 82f. The number of vertical supports, such as vertical supports 84a-84e, can vary depending on various factors, including the length of the hot aisle module. Also, as stated, the side walls of the hot aisle modules of some embodiments of this invention may not have any vertical supports.

In the hot aisle module of the embodiment of this invention illustrated in Figures 1-7, similar to side wall 28, side wall 30 of chute 22 includes a series of panels 30a-30k, the upper portions of legs 24h-24n and panel framework. *See* Figures 1 and 2. Panels 30a-30k are (1) supported and retained by the upper portions of legs 24h-24n and the panel framework and (2) arranged in a row edge-to-edge. *See* Figure 2. While, in the hot aisle module of this embodiment of the invention, side wall 30 includes panels 30a-30k, as stated, any number of panels can be used to form the side walls of the hot air modules of other embodiments of this invention, including a single panel. Panels 30a-30k can be made of the same material as panels 28a-28k.

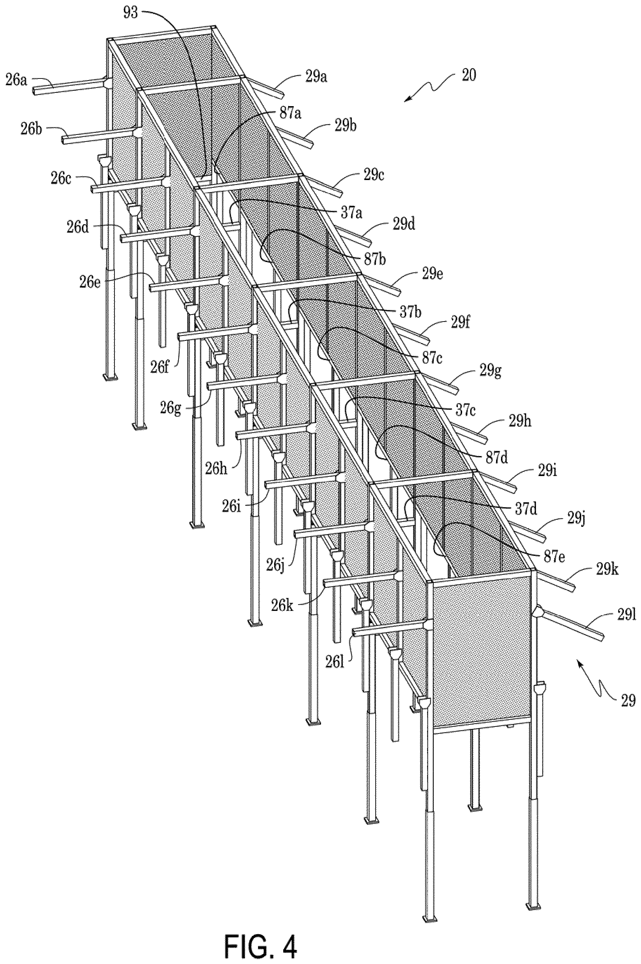

Also, similar to the panel framework of side wall 28, the panel framework that supports and retains panels 30a-30k includes top longitudinal supports 86a-86f, bottom longitudinal supports 87a-87f (bottom longitudinal support 87f is not visible in the figures), and vertical supports 90a-90e. *See* Figures 2 and 4. As stated, the side walls of hot aisle modules of other embodiments of this invention may have only some or none of those panel supports and retaining members, or other panel supporting and retention means.

Panels 30a-30k can be attached to legs 24h-24n, top longitudinal supports 86a-86f, bottom longitudinal supports 87a-87f, and vertical supports 90a-90e in the same manners that panels 28a-28k can be attached to legs 24a-24g, top longitudinal supports 80a-80f, bottom longitudinal supports 82a-82f, and vertical supports 84a-84e, as discussed above.

In the hot aisle module of this embodiment of the invention, top longitudinal support 86a and bottom longitudinal support 87a extend between and are connected at their ends to legs 24h and 24i, top longitudinal support 86b and bottom longitudinal support 87b extend between and are connected at their ends to legs 24i and 24j, top longitudinal support 86c and bottom longitudinal support 87c extend between and are connected at their ends to legs 24j and 24k, top longitudinal support 86d and bottom longitudinal support 87d extend between and are connected at their ends to legs 24k and 24l, top longitudinal support 86e and bottom longitudinal support 87e extend between and are connected at their ends to legs 241 and 24m, and top longitudinal support 86f and bottom longitudinal support 87f extend between and are connected at their ends to legs 24m and 24n. In the hot aisle modules of other embodiments of this invention, one or both of the sets of top longitudinal supports and the bottom longitudinal supports can be an integral, one-piece member.

Vertical supports 90a-90e extend between and are connected at their ends to top longitudinal supports 86b-86f and bottom longitudinal supports 87b-87f, respectively. Specifically, vertical support 90a extends between and is connected at its ends to top longitudinal support 86b and bottom longitudinal support 87b, vertical support 90b extends between and is connected at its ends to top longitudinal support 86c and bottom longitudinal support 87c, vertical support 90c extends between and is connected at its ends to top longitudinal support 86d and bottom longitudinal support 87d, vertical support 90d extends between and is connected at its ends to top longitudinal support 86e and bottom longitudinal support 87e, and vertical support 90e extends between and is connected at its ends to top longitudinal support 86f and bottom longitudinal support 87f. The number of vertical supports, such as vertical supports 90a-90e, can vary depending on various factors, including the length of the hot aisle module. As stated, in the hot aisle modules of some embodiments of this invention, the side walls of the hot aisle modules may not have any vertical supports.

In the hot aisle module of this embodiment of the invention, end wall 32 of chute 22 includes a single panel, panel 33, the upper portions of legs 24a and 24h, and panel framework. The upper portions of legs 24a and 24h and the panel framework support and retain panel 33. The panel framework includes top longitudinal support 92 and bottom longitudinal support 93. *See* Figures 2 and 4. Top longitudinal support 92 and bottom longitudinal support 93 extend between and are connected at their ends to legs 24a and 24h.

Similarly, end wall 34 of chute 22 includes a single panel, panel 35, the upper portions of legs 24g and 24n, and panel framework. The upper portions of legs 24g and 24n and the panel framework support and retain panel 35. The panel framework includes top longitudinal support 94 and bottom longitudinal support 96. *See* Figure 2. Top longitudinal support 94 and bottom longitudinal support 96 extend between and are connected at their ends to legs 24g and 24n.

Panel 33 can be attached to the upper portions of legs 24a and 24h, top longitudinal support 92 and bottom longitudinal support 93, and panel 35 can be attached to the upper portions of legs 24g and 24n, top longitudinal support 94 and bottom longitudinal support 96, in the same manners that panels 28a-28k can be attached to legs 24a-24g, top longitudinal supports 80a-80f, bottom longitudinal supports 82a-82f, and vertical supports 84a-84e, as discussed above.

Panels 33 and 35 can be made of the same material as panels 28a-28k and panels 30a-30k.

The end walls of hot aisle modules of other embodiments of this invention may have only some of the above described panel supports and retaining members, or other panel supporting and retention means.

Also, in the hot aisle modules of other embodiments of the invention, each of the end walls can have more than one panel, depending on the application and as desired.

As can be determined from the figures, in the hot aisle module of this embodiment of the invention, side walls 28 and 30 and end walls 32 and 34 have fixed heights. In the hot aisle modules of other embodiments of this invention, the heights of the side walls and/or the end walls can be variable, such as by providing panels and/or supports comprised of two or more sections that are slidable vertically with regard to each other.

The heights of end walls 32 and 34 can differ from the heights of side walls 28 and 30.

Because, in the hot aisle module of this embodiment of the invention, side wall 28 and end wall 32 both include the upper portion of leg 24a, side wall 28 and end wall 34 both include the upper portion of leg 24g, side wall 30 and end wall 32 both include the upper portion of leg 24h, and side wall 30 and end wall 34 both include the upper portion of leg 24n, side walls 28 and 30 and end walls 32 and 34 are essentially fixedly attached to one other. However, in the hot aisle modules of other embodiments of this invention, one or more of the side walls and the end walls can be slidable relative to the other side walls and end walls. That will enable one or more of side walls and end walls to be adjusted, height-wise, relative to the other side walls and end walls.

Chute 22 includes upper cross supports 36a-36e, which extend between and are connected at their ends to pairs of the legs of hot aisle module 20. *See* Figure 1. Specifically, upper cross support 36a extends between and is connected at its ends to the upper ends of legs 24b and 24i, upper cross support 36b extends between and is connected at its ends to the upper ends of legs 24c and 24j, upper cross support 36c extends between and is connected at its ends to the upper ends of legs 24d and 24k, upper cross support 36d extends between and is connected at its ends to the upper ends of legs 24e and 241, and upper cross support 36e extends between and is connected at its ends to the upper ends of legs 24f and 24m. While the hot aisle module of this embodiment of the invention includes upper cross supports 36a-36e, in other embodiments, the number of upper cross supports can be any number. Moreover, in the hot aisle modules of yet other embodiments of the invention, the upper cross supports may extend between and be connected to the longitudinal supports of the side walls instead of the legs. In addition, the hot aisle modules of some embodiments of this invention may not have any upper cross supports.

Upper cross supports 36a-36e are in substantially the same horizontal planes as top longitudinal supports 80a-80f of side wall 28, top longitudinal supports 86a-86f of side wall 30, top longitudinal support 92 of end wall 32 and top longitudinal support 94 of end wall 34.

Chute 22 also includes lower cross supports 37a-37e (lower cross support 37e is not visible in the figures), which also extend between and are connected at their ends to pairs of the legs of hot aisle module 20. *See* Figure 4. Lower cross supports 37a-37e are in substantially the same horizontal planes as bottom longitudinal support 82a-82f of side wall 28, the bottom longitudinal supports of side wall 30, the bottom longitudinal support of end wall 32 and bottom longitudinal support 96 of end wall 34.

In the hot aisle module of this embodiment of the invention, there is a lower cross support for each upper cross support. Thus, lower cross support 37a extends between and is connected at its ends to legs 24b and 24i, lower cross support 37b extends between and is connected at its ends to legs 24c and 24j, lower cross support 37c extends between and is connected at its ends to legs 24d and 24k, lower cross support 37d extends between and is connected at its ends to legs 24e and 241, and lower cross support 37e extends between and is connected at its ends to legs 24f and 24m. In the hot aisle modules of other embodiments of this invention, the number of lower cross supports can be any number. The number of lower cross supports does not have to match the number of upper cross supports. Moreover, the same as the upper cross supports, the lower cross supports may extend between and be connected to the longitudinal supports of the side walls instead of the legs. In addition, the hot aisle modules of some embodiments of this invention may not have any lower cross supports.

Each of legs 24a-24n is telescopable.

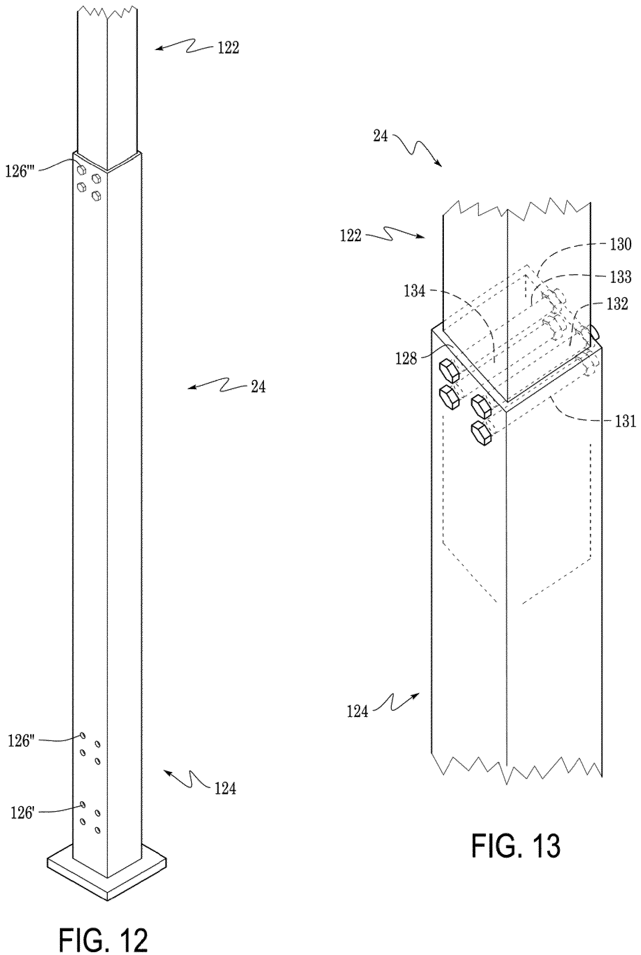

One embodiment of telescopable legs 24a-24n is illustrated in Figure 12, leg 24. Leg 24 includes upper leg portion 122 and lower leg portion 124. When upper leg portion 122 and lower leg portion 124 are disconnected, upper leg portion 122 can slide relative to lower leg portion 124, within lower leg portion 124.

Lower leg portion 124 includes sets of bolt holes spaced longitudinally along lower leg portion 124. There are matching sets of bolt holes in front wall 128 and back wall 130 of lower leg portion 124. *See* Figure 13.

In the embodiment illustrated in Figure 12, lower leg portion 124 includes sets of bolt holes 126', 126" and 126'''. In other embodiments of the hot aisle modules of this invention, the number of sets of bolt holes can vary from one to a limit determined by the length of lower leg portion 124. Each of the sets of bolt holes includes the same number, size, location and spacing of bolt holes as the other sets.

Also, in this embodiment of the invention, each of sets of bolt holes 126', 126" and 126''' includes four bolt holes. In other embodiments of the hot aisle modules of this invention, each set of bolt holes can consist of other than four bolt holes, including one bolt hole.

Upper leg portion 122 also includes at least one set of bolt holes (not shown in the figures). The bolt holes of the set of bolt holes in upper leg portion 122 are sized and located to correspond to the bolt holes of each of the sets of bolt holes 126', 126" and 126'''. As with the sets of bolt holes 126', 126" and 126''', there are matching sets of bolt holes in the front wall and rear wall of upper leg portion 122.

Bolt assemblies 131-134 (*see* Figure 13) are received in one of sets of bolt holes 126', 126" and 126''' in lower leg portion 124 and the at least one set of bolt holes in upper leg portion 122 to fix upper leg portion 122 in a fixed position relative to lower leg portion 124.

While in the embodiment of the leg of the hot aisle module of this invention illustrated in Figures 12 and 13 utilizes bolt assemblies to fix upper leg portion 122 relative to lower leg portion 124, in other embodiments, other fastening means can be employed.

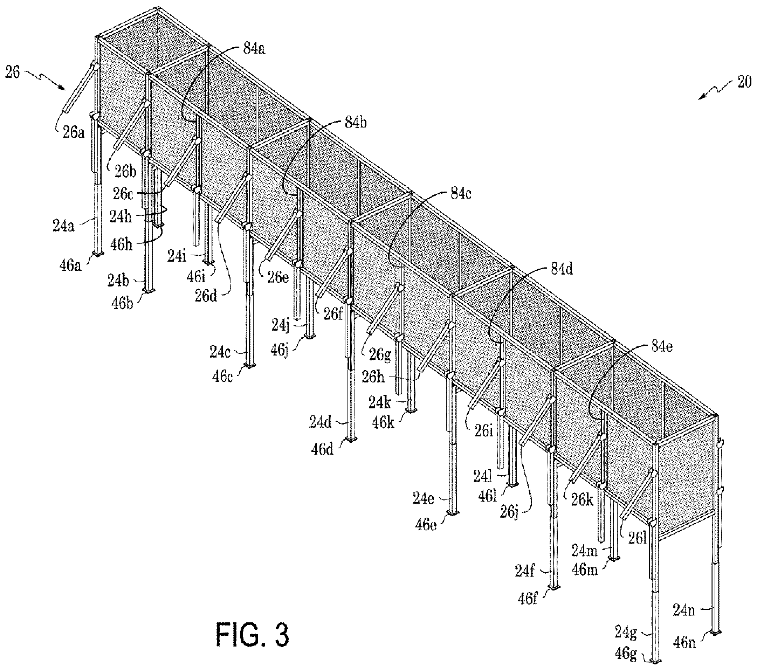

In addition, each of legs 24a-24n includes a bottom platform plate 46a-46n, respectively. *See* Figure 3. Bottom platform plates 46a-46n can be attached to a subfloor or other floor structure or rest on an access floor, subfloor or other floor structure.

In the hot aisle module of this embodiment of the invention, (1) legs 24a-24n, (2) top longitudinal supports 80a-80f, bottom longitudinal supports 82a-82f, and vertical supports 84a-84e of side wall 28, (3) top longitudinal supports 86a-86f, bottom longitudinal supports 87a-87f, and vertical supports 90a-90e of side wall 30, (4) top longitudinal support 92 and bottom longitudinal support 93 of end wall 32, (5) top longitudinal support 94 and bottom longitudinal support 96 of end wall 34, (6) upper cross supports 36a-36e, and (7) lower cross supports 37a-37e are hollow bars with bolt holes as necessary for joinder to other of the supports by brackets and bolt assemblies, as described in more detail below. In the hot aisle modules of other embodiments of the invention, one or more of those members can be any combination of I-beams, T-bars, channels or any other structural members having the requisite structural stability.

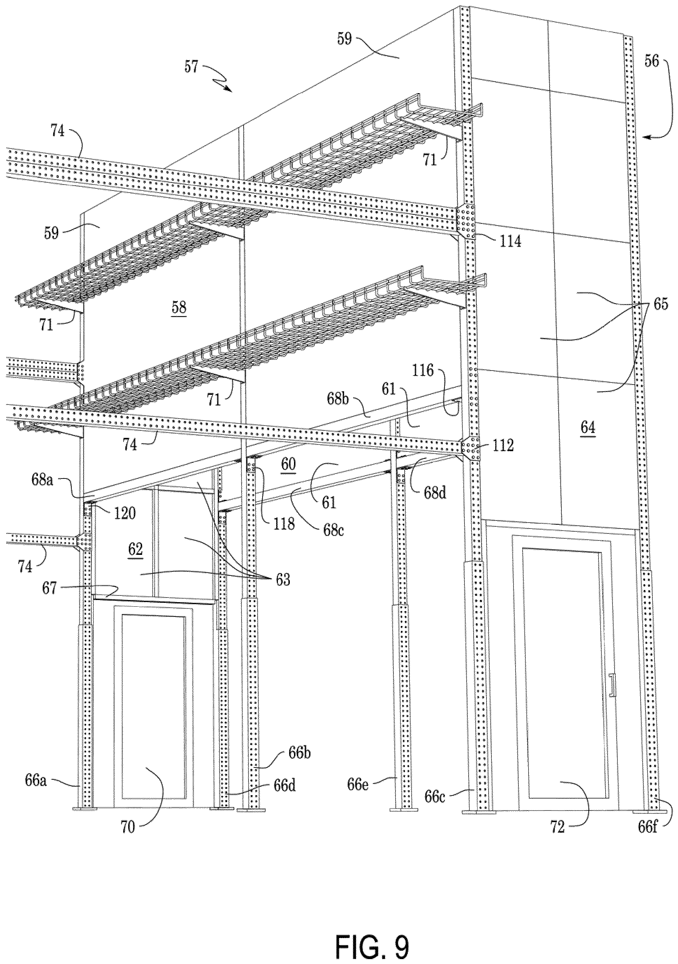

The various support members can be attached to one another by brackets that (1) span two of the support members and (2) are bolted or otherwise affixed to those two support members. For example, top longitudinal support 80a can be attached to leg 24a by an angle bracket having one leg attached to the longitudinal support 80a and the other leg attached to leg 24a. Such bracket and bolt assemblies are shown in more detail in Figure 9 and further described below.

As stated above, the hot aisle module of this embodiment of the invention includes set 26 of foldable side arms 26a-261, set 27 of foldable side arms 27a-271, set 29 of foldable side arms 29a-291 and set 31 of foldable side arms 31a-31l. Set 26 of foldable side arms 26a-261 and set 27 of foldable side arms 27a-271 are on one side of hot aisle module 20 and set 29 of foldable side arms 29a-291 and set 31 of foldable side arms 31a-311 are on the other side of hot aisle module 20.

While, the hot aisle module of this embodiment of the invention includes two sets of foldable side arms on each side of hot aisle module 20, the hot aisle modules of other embodiments may include (1) no foldable side arms on one side of the module and one or more sets of foldable side arms on the other side of the module or (2) any number of sets of foldable side arms on each side of the module, including one set. With regard to (2), there can be a different number of sets of foldable side arms on each side of the module. In the hot aisle modules of yet other embodiments, the hot aisle module may not have any foldable side arms, or any side arms of any type.

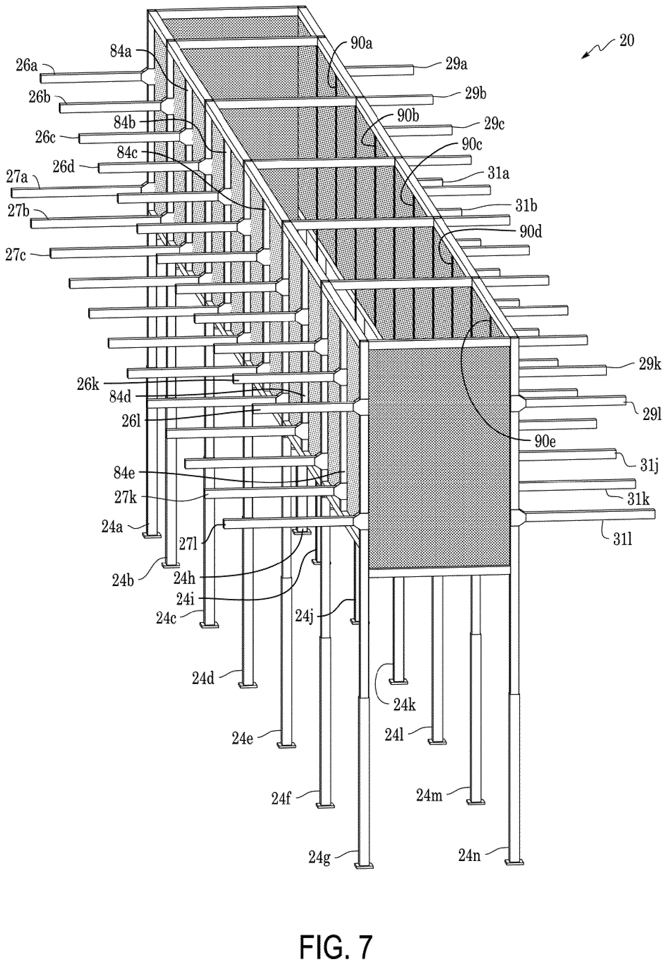

Each of set 26 of foldable side arms 26a-26l, set 27 of foldable side arms 27a-27l, set 29 of foldable side arms 29a-291 and set 31 of foldable side arms 31a-311 is pivotably attached to a leg or a vertical support of side walls 28 and 30. More specifically, foldable side arms 26a and 27a are pivotably attached to leg 24a, foldable side arms 26b and 27b are pivotably attached to leg 24b, foldable side arms 26c and 27c are pivotably attached to vertical support 84a, foldable side arms 26d and 27d are pivotably attached to leg 24c, foldable side arms 26e and 27e are pivotably attached to vertical support 84b, foldable side arms 26f and 27f are pivotably attached to leg 24d, foldable side arms 26g and 27g are pivotably attached to vertical support 84c, foldable side arms 26h and 27h are pivotably attached to leg 24e, foldable side arms 26i and 27i are pivotably attached to vertical support 84d, foldable side arms 26j and 27j are pivotably attached to leg 24f, foldable side arms 26k and 27k are pivotably attached to vertical support 84e, foldable side arms 261 and 271 are pivotably attached to leg 24g, foldable side arms 29a and 31a are pivotably attached to leg 24h, foldable side arms 29b and 31b are pivotably attached to leg 24i, foldable side arms 29c and 31c are pivotably attached to vertical support 90a, foldable side arms 29d and 31d are pivotably attached to leg 24j, foldable side arms 29e and 31e are pivotably attached to vertical support 90b, foldable side arms 29f and 31f are pivotably attached to leg 24k, foldable side arms 29g and 31g are pivotably attached to vertical support 90c, foldable side arms 29h and 31h are pivotably attached to leg 241, foldable side arms 29i and 31i are pivotably attached to vertical support 90d, foldable side arms 29j and 31j are pivotably attached to leg 24m, foldable side arms 29k and 31k are pivotably attached to vertical support 90e, and foldable side arms 291 and 31l are pivotably attached to leg 24n. *See, e.g.,* Figure 7.

Each of foldable side arms 26a-261, 27a-27l, 29a-291 and 31a-31l is pivotable between a down or folded position and an up or open position about axes that are substantially perpendicular to legs 24a-24n. When foldable side arms 26a-261, 27a-271, 29a-291 and 31a-311 are in their down or folded positions, they are substantially parallel to legs 24a-24n. When foldable side arms 26a-261, 27a-271, 29a-29l and 31a-311 are in their up or open positions, they are substantially perpendicular to legs 24a-24n.

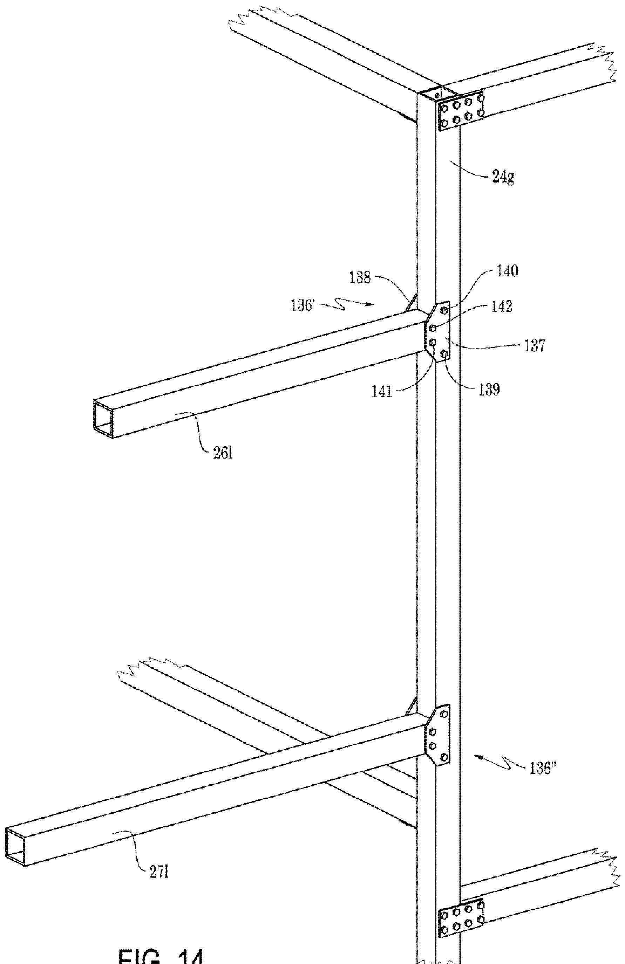

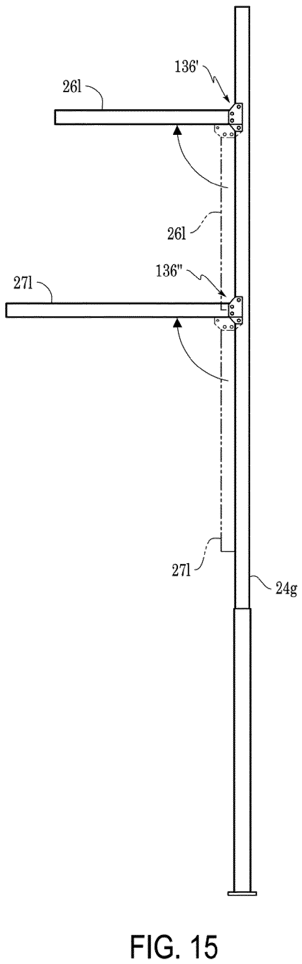

One mechanism and manner for rotatably attaching foldable side arms 26a-261, 27a-27l, 29a-291 and 31a-311 to their respective supporting legs or vertical supports is illustrated in Figures 14 and 15. In those figures, side arms 261 and 271 are rotatably attached to leg 24g by bracket assemblies 136' and 136".

Each of bracket assemblies 136' and 136" includes two plates, plates 137 and 138 and four bolt assemblies, lower leg bolt assembly 139, upper leg bolt assembly 140 and two foldable side arm bolt assemblies 141 and 142. Foldable side arms 261 and 271 are attached to plates 137 and 138 by foldable side arm bolt assemblies 141 and 142. Plates 137 and 138 are attached to leg 24g by lower leg bolt assembly 139 and upper leg bolt assembly 140.

As shown in Figure 15, when foldable side arms 261 and 271 are in their down or folded positions, upper leg bolt assemblies 140 are detached from plates 137 and 138 and leg 24g, such that plates 137 and 138, and, thus, side arms 261 and 271, can rotate around lower leg bolt assemblies 139. When it is desired to rotate foldable side arms 261 and 271 from their down or folded positions to their up or open positions, bracket plates 137 and 138 of bracket assemblies 136'and 136", and, thus, foldable side arms 261 and 271 are rotated about lower leg bolt assemblies 139 until foldable side arms 261 and 271 are in their up or open positions. Upper leg bolt assemblies 140 are then connected to plates 137 and 138 and leg 24g to maintain foldable side arms 261 and 271 in their up or open positions.

In the hot aisle modules of other embodiments of the invention having foldable side arms, each of the foldable side arms can pivot between an up or folded position and a down or open position about axes that are also substantially perpendicular to the legs of the modules. That is, whereas the pivot axes for foldable side arms 26a-261, 27a-271, 29a-291 and 31a-311 are at the top ends of the foldable side arms (when they are in their folded positions), in those other embodiments, the pivot axes can be at the bottom ends of the foldable side arms (when they are in their folded positions). In the hot aisle modules of yet other embodiments of the invention having foldable side arms, the foldable side arms can rotate around axes that are substantially parallel to the legs of the modules.

As stated, foldable side arms, and in fact, side arms of any type, are optional for the hot aisle modules of this invention. That is, the hot aisle modules of some embodiments of this invention do not have any side arms. In addition, even for some of the hot aisle modules of this invention that include side arms, the side arms can be detachable or attached to the other components of the hot aisle modules in any manner which permits them to be moved from a closed position to an open position and vice versa.

No matter how the side arms, such as foldable side arms 26a-261, 27a-271, 29a-291 and 31a-31l, are attached to the rest of the hot aisle modules, the side arms must have sufficient length and strength to support cable trays, bus bars and/or other data room service items when in their up or open positions.

Also, while in the hot aisle module of this embodiment of the invention, foldable side arms 26a-261, 27a-271, 29a-291 and 31a-311 are individually rotatable between their down or closed positions and their up or open positions, the hot aisle modules of other embodiments may include mechanisms that move the foldable side arms of each set of foldable side arms synchronously.

Figures 1-7 illustrate hot aisle module 20 in various states. In Figure 1, hot aisle module 20 is illustrated with legs 24a-24n in their most retracted positions and all of foldable side arms 26a-261, 27a-271, 29a-291 and 31a-31l in their down or folded positions. In this state, hot aisle module 20 has its lowest profile, height-wise and width-wise.

Figure 2 illustrates hot aisle module 20 with legs 24a-24n in expanded or extended positions, but with all of foldable side arms 26a-261, 27a-271, 29a-291 and 31a-31l still in their down or folded positions.

Figure 3 illustrates hot aisle module 20 with (1) legs 24a-24n in expanded or extended positions, (2) set 26 of foldable side arms 26a-261, set 29 of foldable side arms 29a-291 and set 31 of foldable side arms in their down or folded positions, and (3) set 27 of foldable side arms 27a-271 being rotated from their down or folded positions to their up or open positions.

Figure 4 illustrates hot aisle module 20 with (1) legs 24a-24n in expanded or extended positions, (2) set 27 of foldable side arms 27a-271 in their up or open positions, (3) set 26 of foldable side arms 26a-261 and set 31 of foldable side arms 31a-311 in their down or folded positions, and (4) set 29 of foldable side arms 29a-291 being rotated from their down or folded positions to their up or open positions.

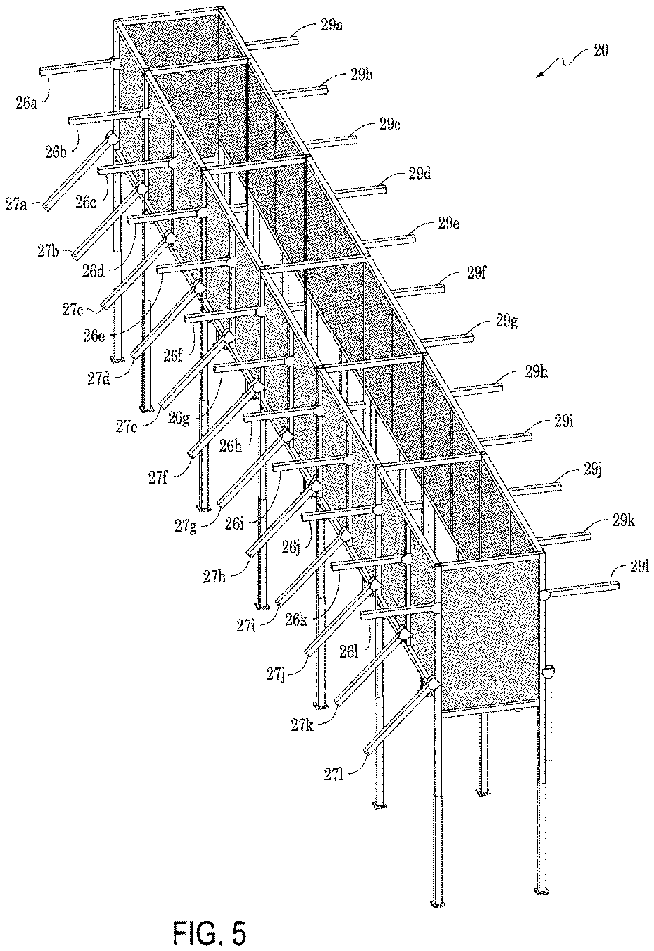

Figure 5 illustrates hot aisle module 20 with (1) legs 24a-24n in expanded or extended positions, (2) set 26 of foldable side arms 26a-261 and set 29 of foldable side arms 29a-291 in their up or open positions, (3) set 31 of foldable side arms 31a-31l in their down or folded positions, and (4) set 27 of foldable side arms 27a-271 being rotated from their down or folded positions to their up or open positions.

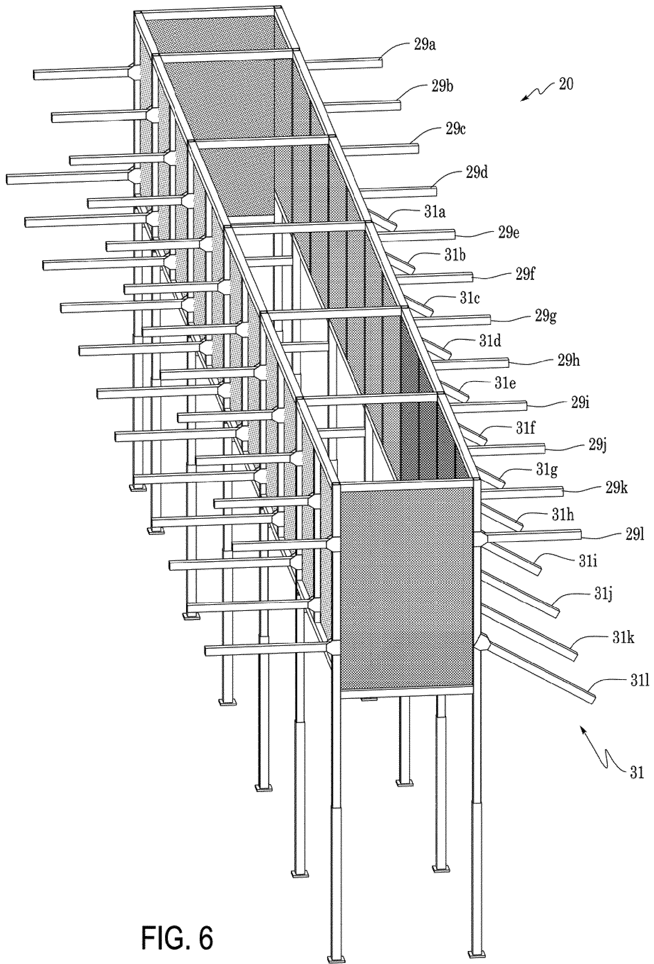

Figure 6 illustrates hot aisle module 20 with (1) legs 24a-24n in expanded or extended positions, (2) set 26 of foldable side arms 26a-261, set 27 of foldable side arms 27a-271 and set 29 of foldable side arms 29a-29k in their up or open positions, and (3) set 31 of foldable side arms 31a-31l being rotated from their down or folded positions to their up or open positions.

Figure 7 illustrates hot aisle module 20 with (1) legs 24a-24n in expanded or extended positions and (2) all of foldable side arms 26a-261, 27a-271, 29a-291 and 31a-31l in their up or open positions.

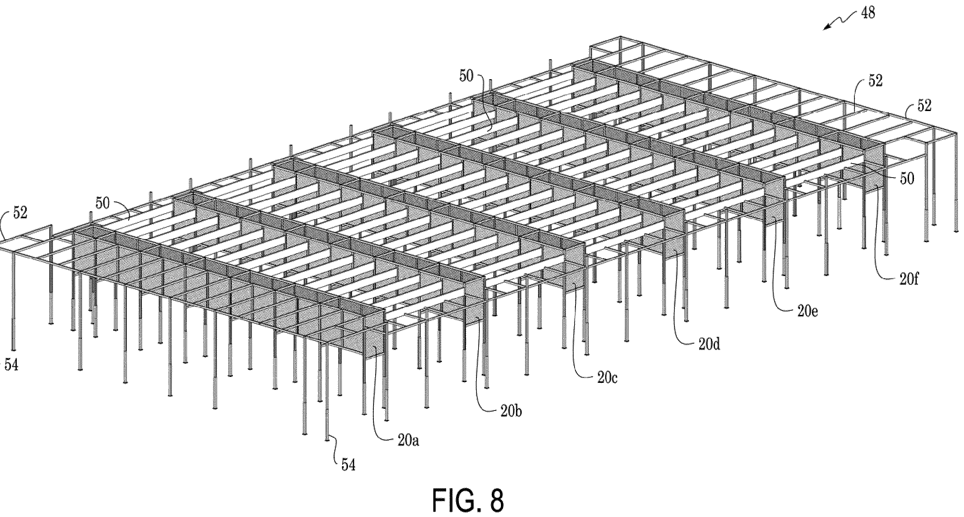

Figure 8 illustrates one embodiment of a hot aisle containment system according to this invention, hot aisle containment system 48. Hot aisle containment system 48 includes a plurality of hot aisle modules 20a-20f with interconnecting and surrounding framework. As stated, hot aisle containment system 48 can be installed in a data center or other IT or computer facility.

Hot aisle modules 20a-20f are arranged in a row, with (1) modules 20a-20f being substantially parallel, (2) their respective end walls 32 in substantially the same vertical plane, and (3) their respective end walls 34 in substantially the same vertical plane. While hot aisle containment system 48 includes hot aisle modules 20a-20f, the hot aisle containment systems of other embodiments of this invention may include any number of hot aisle modules, arranged in a row or otherwise.

Each of hot aisle modules 20a-20f is connected to the adjacent hot air module(s) 20a-20f by girders 50. Girders 50 extend between and are attached at their ends to adjacent ones of hot aisle modules 20a-20f. More specifically, girders 50 extend between and are attached at their ends to legs 24a-24n, vertical supports 84a-84e and vertical supports 90a-90e of the various modules 20a-20f. While, in the hot aisle containment system of this embodiment of the invention, there is a girder 50 attached to each leg 24a-24n and vertical support 84a-84e and 90a-90e of a hot aisle module that faces another hot aisle module, in the hot aisle containment systems of other embodiments, it may not be necessary to have a girder attached to every such leg and vertical support. Also, in the hot aisle containment systems of other embodiments of this invention, the girders can be attached to other components of the hot aisle modules.

Girders 50 can be hollow bars, I-beams, T-bars, channels or any other structural members having the requisite structural stability. Girders 50 can be affixed to the legs and vertical supports by bracket and bolt assemblies such as the bracket and bolt assemblies illustrated in Figure 9 and discussed below.

In the hot aisle containment systems of other embodiments of the invention, the hot aisle modules can be connected by structural members other than girders.

The surrounding framework includes horizontal members 52 and supplemental legs 54. Horizontal members 52 are exterior to the array of hot aisle modules 20a-20f and girders 50 and are attached on their ends to (1) one of the legs and vertical supports of the array of hot aisle modules 20a-20f, (2) one of the girders 50, (3) another horizontal member 52 or (4) one of the supplemental legs 54. Supplemental legs 54 support the ends of horizontal members 52 that are not connected to the legs and vertical supports of the array of hot aisle modules 20a-20f, girders 50 or other horizontal members 52.

The function of horizontal members 52 and supplemental legs 54 is to provide additional support for any service items located above hot air containment system 48, such as cables, ducts, fire protection systems, etc.

In the hot aisle containment systems of other embodiments of this invention, the surrounding framework can be comprised of any types and configurations of members and/or legs that provide the desired support for the data room service items that the framework is intended to support.

While in the hot aisle containment system of this embodiment of the invention, horizontal members 52 extend in every direction from the array of hot aisle modules 20a-20f and girders 50, in the hot aisle containment systems of other embodiments, the horizontal members may extend from only one, two or three sides of the array of hot aisle modules and the associated girder system. In addition, the hot aisle containment systems of yet other embodiments may not include any such horizontal members and supplemental legs, such that the systems only include a plurality of hot aisle containment system modules and connecting members.

Similar to girders 50, horizontal members 52 and supplemental legs 54 can be hollow bars, I-beams, T-bars, channels or any other structural member having the requisite structural stability.

As stated, a portion of a hot aisle containment system of another embodiment of this invention is illustrated in Figure 9. The illustrated portion includes hot aisle module 56 and girders 74.

Hot aisle module 56 includes chute 57 and telescopable legs 66a-66f (the upper portions of which define, in part, chute 57, as discussed below).

Chute 57 includes side walls 58 and 60 and end walls 62 and 64. Like chute 22, chute 57 has an open top and an open bottom and is rectangular in cross section.

Side wall 58 includes a plurality of panels 59, the upper portions of legs 66a-66c, and lower supports 68a and 68b. The upper portions of legs 66a-66c and lower supports 68a and 68b support and retain panels 59.

Lower support 68a extends between and is connected at its ends to legs 66a and 66b. Lower support 68b extends between and is connected at its ends to legs 66b and 66c.

Similarly, side wall 60 includes a plurality of panels 61, the upper portions of legs 66d-66f, and lower supports 68c and 68d. The upper portions of legs 66d-66f and lower supports 68a and 68b support and retain panels 61.

Lower support 68c extends between and is connected at its ends to legs 66d and 66e. Lower support 68d extends between and is connected at its ends to legs 66e and 66f.

End wall 62 includes a plurality of panels 63, the upper portions of legs 66a and 66d, and cross support 67. The upper portions of legs 66a and 66d and cross support 67 support and retain panels 63.

Similarly, end wall 64 includes a plurality of panels 65, the upper portions of legs 66c and 66f, and other supporting and retention members not visible in Figure 9. The upper portions of legs 66c and 66f and the other panel supporting and retaining members support and retain panels 65.

Panels 59 can be attached to the upper portions of legs 66a-66c and lower supports 68a and 68b, panels 61 can be attached to the upper portions of legs 66d-66f and lower supports 68c and 68d, panels 63 can be attached to the upper portion of legs 66a and 66d and cross support 67, and panels 65 can be attached to the upper portions of legs 66c and 66f and its other supporting and retention member in the same manners that panels 28a-28k can be attached to legs 24a-24g, top longitudinal supports 80a-80f, bottom longitudinal supports 82a-82f and vertical supports 84a-84g, as discussed above.

In application, end walls 62 and 64 can be positioned such that door assemblies 70 and 72, respectively, can be installed beneath them and between legs 66a and 66d and legs 66c and 66f, respectively.

In the hot aisle containment system of this embodiment of the invention, side support brackets 71 are attached to one or more of legs 66a-66f either in the factory or in the field. Side support brackets 71 are of a sufficient length and strength to support cable trays, bus bars and other data room service items.

Girders 74 extend between and are attached on their ends to one of legs 66a-66f of adjacent hot aisle modules 56.

Girders 74 and lower supports 68a-68d are attached to legs 66a-66f by bracket and bolt assemblies that (1) span two of the members and (2) are attached to those two members. For example, as illustrated in Figure 9, girders 74 are attached to leg 66c by plate bracket and bolt assemblies 112 and 114, and lower supports 68a and 68b are attached to legs 66a-66c by angle bracket and bolt assemblies 116, 118 and 120.

One method of installing the hot aisle modules and the hot aisle containment systems of this invention is as follows.

First, the hot aisle modules can be constructed off site or on site. Construction off site may often be preferred to reduce installation time at the job site and to reduce the risk of interference with other trades working at the same job site.

If the modules are constructed off site, they can be transported to the job site with their legs in their most retracted positions and the side arms (if any) in their down or folded positions or disconnected from the modules. This minimizes the shipping space per module required to ship the modules from the manufacturing site to the job site where they are to be installed and also makes it easier to maneuver the modules during shipping.

Once at the job site, the modules can be transported on skids or otherwise to the desired locations within the job site, with their legs still in their most retracted positions and their side arms (if any) still in their down or folded positions or disconnected from the modules. Again, having the legs and arms in those positions makes it easier to maneuver the modules into and around the job site.

Once the modules are positioned as desired, their legs can be expanded or extended until their chutes are at the desired heights. Those heights are usually such that the bottoms of the chutes are immediately adjacent the tops of the IT racks and/or cabinets of the rows of IT racks and/or cabinets that form the hot aisle containing the module and/or immediately below the air exhaust vent above the chute. The legs of a given module can be expanded or extended such that the legs have the same length, or different legs of a given module can be expanded or extended to different lengths, depending on the application.

If the modules have foldable side arms, the side arms are pivoted from their folded positions to their open positions. If detachable side arms are included, they are now attached to the modules.

Next, adjacent hot aisle modules can be connected by interconnecting members, such as girders 50 and 74.

Finally, any desired supplemental horizontal members and supplemental legs, such as horizontal members 52 and supplemental legs 54, can be attached to the array of hot aisle modules and interconnecting members as desired.

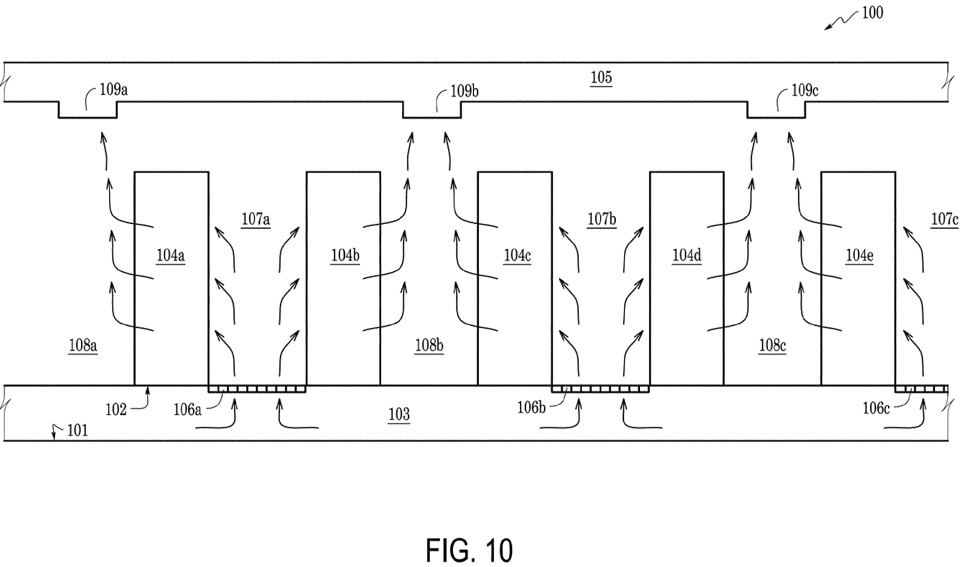

As stated, one environment in which the hot aisle modules and the hot aisle containment systems of this invention can be installed and used is a data center, such as data center 100. *See* Figure 10. A typical data center such as data center 100 includes subfloor 101, access or raised floor 102, a plurality of rows 104a-104e of IT racks and/or cabinets on access or raised floor 102, air exhaust system 105, cold aisles 107a-107c and hot aisles 108a-108c.

Access or raised floor 102 is comprised of an array of access or raised floor panels arranged edge-to-edge and supported on pedestals or other structural members above subfloor 101.

Plenum 103 is formed between access or raised floor 102 and subfloor 101. Cooling air from the facility's cooling air generator (not shown in Figure 10) is directed into plenum 103.

Some of the access or raised floor panels comprising access or raised floor 102 are grate panels, such as grate panels 106a-106c in Figure 10. Cooling air passes from plenum 103 through grate panels 106a-106c.

The cooling air that passes through grate panels 106a-106c enters cold aisles 107a-107c, respectively. The intent is for the cooling air to then exit cooling aisles 107a-107c and enter and pass through rows 104a-104e of IT racks and/or cabinets. Specifically, with reference to Figure 10, it is intended that the cooling air from cold aisle 107a enter and pass through rows 104a and 104b, the cooling air from cold aisle 107b enter and pass through rows 104c and 104d, and the cooling air from cold aisle 107c enter and pass through row 104e.

It is next intended that the cooling air exit rows 104a-104e of IT racks and/or cabinets and enter hot aisles 108a-108c. Specifically, again with reference to Figure 10, it is intended that the cooling air that passes through row 104a enters hot aisle 108a, the cooling air that passes through rows 104b and 104c enters hot aisle 108b, and the cooling air that passes through rows 104d and 104e enters hot aisle 108c. Because the cooling air is heated by the computer and other IT equipment in and on rows 104a-104e of IT racks and/or cabinets, the cooling air is turned into hot air as it passes through rows 104a-104e.

Air exhaust system 105 includes exhaust vents 109a-109c. It is intended that the hot air from hot aisles 108a-108c exit data center 100 via exhaust vents 109a-109c, respectively.

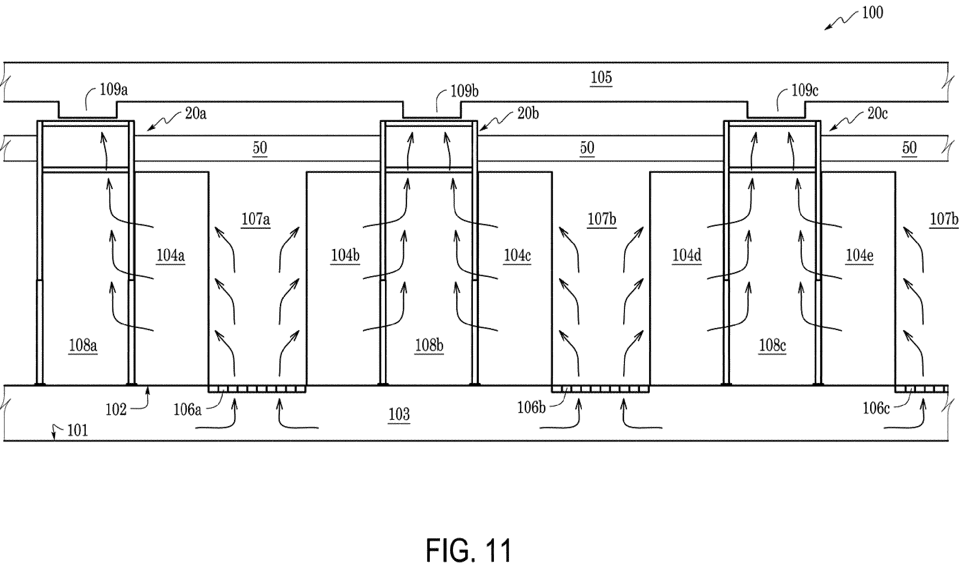

As stated, Figure 11 illustrates a portion of hot aisle containment system 48 installed in data center 100. As can be determined, the legs of hot aisle modules 20a-20c are expanded or extended such that the chutes of modules 20a-20c extend from immediately above rows 104a-104e of IT racks and/or cabinets to immediately below exhaust vents 109a-109c to direct hot air from hot aisles 108a-108c to exhaust vents 109a-109c. If desired, sealing strips (not shown) can be added between (1) the chutes of modules 20a-20c and rows 104a-104e of IT racks and/or cabinets and/or (2) the chutes of modules 20a-20c and the ceiling of data center 100 to reduce the risk of the hot air exiting or cooling air entering between (1) the chutes of modules 20a-20c and rows 104a-104e of IT racks and/or cabinets and/or (2) the chutes of modules 20a-20c and the ceiling.

The hot aisle modules and hot aisle containment systems of this invention have various features that are highly desirable, including at least the following.

First, as stated, the height of the modules can be minimized, by retracting their legs as much as possible, and the width of the modules can be minimized, if they have the optional side arms, by having the side arms in their folded positions or removed, for transport of the modules from the factory to the desired installation site, and, once at the desired installation site, for transport of the modules into and positioning in the site.

Second, once the modules are in place, their legs can be expanded or extended such that the bottoms of the chutes of the modules are immediately above the IT racks and cabinets of the adjacent rows of IT racks and/or cabinets and/or the tops of the chutes are immediately adjacent exhaust vents, and the legs locked in that position. If the modules include foldable or removable side arms, the side arms can be (1) rotated or otherwise moved from their folded positions to their open positions or (2) attached to the modules.

Third, the hot aisle modules and the hot aisle containment systems of this invention provide a very effective way to route the hot air from the hot aisles to the exhaust vents while minimizing the risk of the hot air intermingling with the cooling air.

Fourth, the modules and containment systems can support service items in the IT or computer facility in which they are installed, such as cables, vents and fire protection systems.

The first two features result in at least these benefits: (1) the modules can be built off site; (2) the modules can be readily transported by truck or other means from the factory to the desired installation site; (3) the modules can be readily transported into the installation site and positioned in the desired locations in the installation site floor plan; and (4) the chutes can be readily positioned as desired vertically. Those features and benefits result in lower costs because the modules can be factory assembled versus field assembled and the transport and installation costs are minimized.

## Claims

1. A hot aisle module (20a-20f) for an IT or computer facility comprising:
a chute (22) forming an air passageway enclosure with an open top and an open bottom; and
legs (24a-24n) with lower ends configured to rest on a floor of the IT or computer facility;
wherein the chute (22) is supported by the legs (24a-24n);
**characterized in that**
the legs are telescopable, and **in that** the height of the chute (22) can be adjusted in a hot aisle of the IT or computer facility by telescoping the telescopable legs (24a-24n) to direct hot air from the hot aisle to an exhaust system of the IT or computer facility.

2. A hot aisle module (20a-20f) for an IT or computer facility according to claim 1, wherein the chute (22) is formed by spaced side walls (28, 30) and spaced end walls (32, 34) that are connected at their ends to form an open-ended box.

3. A hot aisle module (20a-20f) for an IT or computer facility according to claim 2, wherein the telescopable legs (24a-24n) are spaced along the side walls (28, 30) of the chute (22) and the side walls include panels (28a-28k, 30a-30k) that are supported and retained by the telescopable legs.

4. A hot aisle module (20a-20f) for an IT or computer facility according to claim 2 or 3, wherein:
the spaced side walls (28, 30) are first and second side walls that are substantially parallel and the spaced end walls (32, 34) are first and second end walls that are substantially parallel; and
each of the first and second end walls are connected on its ends to the first and second side walls.

5. A hot aisle module (20a-20f) for an IT or computer facility according to claim 4, wherein the chute (22) further includes cross support members (50) that extend between and are attached at their ends to the first and second side walls.

6. A hot aisle module (20a-20f) for an IT or computer facility according to any one of claims 1 to 5, further comprising side arms (26a-26 l, 27a-27 l, 29a-29 l, 31a-31 l) attached to the telescopable legs (24a-24n), preferably pivotably attached to the telescopable legs, the side arms (26a-26 l, 27a-27 l, 29a-29 l, 31a-31 l) having a first position in which the side arms do not protrude from the chute (22), preferably the side arms being substantially parallel to the telescopable legs in the first position, and a second position in which the side arms (26a-26 l, 27a-27 l, 29a-29 l, 31a-311) protrude from the chute (22), preferably the side arms being at an angle other than 0° or 180° with the telescopable legs (24a-24n) in the second position, more preferably the side arms being substantially perpendicular to the telescopable legs in the second position.

7. A hot aisle module (20a-20f) for an IT or computer facility according to claim 6, wherein the side arms (26a-26 l, 27a-27 l, 29a-29 l, 31a-31 l) are designed to support cable trays, bus bars and other service items when in the second position.

8. A hot aisle containment system (48) for an IT or computer facility having spaced hot aisles comprising:
a plurality of the hot aisle module (20a-20f) according to any one of claims 1 to 7 located in the hot aisles of the IT or computer facility; and
support members (50) that extend between and are connected to adjacent ones of the plurality of hot aisle module, preferably girders (50) attached at their ends to the telescopable legs (24a-24n) of the adjacent ones of the plurality of spaced hot aisle module, said adjacent ones of the plurality of hot aisle module being preferably substantially parallel.

9. A hot aisle containment system (48) for an IT or computer facility having spaced hot aisles according to claim 8, wherein each of the plurality of hot aisle module (20a-20f) further includes side arms (26a-26 l, 27a-27 l, 29a-29 l, 31a-31 l) attached to the telescopable legs (24a-24n), preferably pivotably attached to the telescopable legs, the side arms having a first position in which the side arms do not protrude from the chute (22) and a second position in which the side arms protrude from the chute (22).

10. A data center (100) comprising:
spaced rows (104a-104e) of IT racks and/or cabinets;
cold aisles (107a-107c) and hot aisles (108a-108c) between the spaced rows of IT racks and/or cabinets, the cold aisles (107a-107c) and the hot aisles (108a-108c) alternating between the spaced rows (104a-104e) of IT racks and/or cabinets;
a hot aisle containment system (48) including:
the hot aisle module (20a-20f) according to any one of claims 1 to 7 in two or more of the hot aisles (108a-108c); wherein the chutes (22) preferably direct air from the hot aisles (108a-108c) to an air exhaust system of the data center (100); and
wherein the bottom of the chutes of the hot aisle modules are positioned above the top of the rows of IT racks and/or cabinets forming the hot aisle; and
support members (50) that extend between and are connected to the hot aisle modules in adjacent hot aisles, preferably girders attached at their ends to the telescopable legs (24a-24n) of the hot aisle modules in the adjacent hot aisles.

11. A cooling system for two rows of IT racks and/or cabinets comprising:
a hot aisle between the two rows of IT racks and/or cabinets that receives hot air exiting from the two rows of IT racks and/or cabinets; and
the hot aisle module (20a-20f) according to any one of claims 1 to 7 in the hot aisle; wherein the chute (22) preferably extends between the top of the two rows of IT racks and/or cabinets and an air exhaust system.

12. A method of installing a hot aisle containment system (48) in an IT or computer facility having spaced rows of IT racks and/or cabinets and alternating hot and cold aisles between the spaced rows of IT racks and/or cabinets, comprising the steps of:
transporting at least two hot aisle modules into the IT or computer facility, each hot aisle module including:
a chute (22) formed of spaced side walls (28, 30) and spaced end walls (32, 34), the spaced side walls and spaced end walls being connected to form an air passageway enclosure with an open top and an open bottom; and
telescopable legs (24a-24n) having retracted and extended positions and with lower ends configured to rest on a floor of the IT or computer facility;
wherein the chute is supported by the telescopable legs;
wherein during at least a portion of the transporting step, the telescopable legs are in the retracted position;
positioning the at least two hot aisle modules (20a-20f) in at least two of the hot aisles of the IT or computer facility;
extending the telescopable legs (24a-24n) of the at least two hot aisle modules until the bottoms of the chutes (22) of the at least two hot aisle modules are above the adjacent rows of IT racks and/or cabinets; and
connecting the at least two hot aisle modules with support members (50) that extend between and are connected to the at least two hot aisle modules.

13. A method of installing a hot aisle containment system in an IT or computer facility having spaced rows of IT racks and/or cabinets and alternating hot and cold aisles between the spaced rows of IT racks and/or cabinets according to claim 12, wherein each hot aisle module (20a-20f) includes side arms (26a-26 l, 27a-27 l, 29a-29 l, 31a-31 l) attached to the telescopable legs (24a-24n), the side arms having a first position in which the side arms do not protrude from the chute and a second position in which the side arms protrude from the chute; and the method further comprising the step of moving the side arms from the first position to the second position after the step of extending the telescopable legs.

## Patentansprüche

1. Ein Warmgangmodul (20a-20f) für eine IT- oder Computereinrichtung, umfassend:
eine Rinne (22), die ein Luftdurchgangsgehäuse mit einer offenen Oberseite und einer offenen Unterseite bildet; und
Beine (24a-24n) mit unteren Enden, die so konfiguriert sind, dass sie auf einem Boden der IT- oder Computereinrichtung aufliegen;
wobei die Rinne (22) von den Beinen (24a-24n) getragen wird;
**dadurch gekennzeichnet, dass**
die Beine teleskopierbar sind, und dass die Höhe der Rinne (22) in einem Warmgang der IT- oder Computereinrichtung durch Teleskopieren der teleskopierbaren Beine (24a-24n) eingestellt werden kann, um Warmluft aus dem Warmgang zu einem Abluftsystem der IT- oder Computereinrichtung zu leiten.

2. Warmgangmodul (20a-20f) für eine IT- oder Computereinrichtung nach Anspruch 1, wobei die Rinne (22) durch beabstandete Seitenwände (28, 30) und beabstandete Endwände (32, 34) gebildet ist, die an ihren Enden verbunden sind, um einen Kasten mit offenem Ende zu bilden.

3. Warmgangmodul (20a-20f) für eine IT- oder Computereinrichtung nach Anspruch 2, wobei die teleskopierbaren Beine (24a-24n) entlang der Seitenwände (28, 30) der Rinne (22) beabstandet sind und die Seitenwände Platten (28a-28k, 30a-30k) umfassen, die von den teleskopierbaren Beinen getragen und gehalten werden.

4. Warmgangmodul (20a-20f) für eine IT- oder Computereinrichtung nach Anspruch 2 oder 3, wobei:
die beabstandeten Seitenwände (28, 30) erste und zweite Seitenwände sind, die im Wesentlichen parallel sind, und die beabstandeten Endwände (32, 34) erste und zweite Endwände sind, die im Wesentlichen parallel sind; und
jede der ersten und zweiten Endwände an ihren Enden mit der ersten und zweiten Seitenwand verbunden ist.

5. Warmgangmodul (20a-20f) für eine IT- oder Computereinrichtung nach Anspruch 4, wobei die Rinne (22) ferner Querstützelemente (50) aufweist, die sich zwischen der ersten und der zweiten Seitenwand erstrecken und an ihren Enden mit diesen verbunden sind.

6. Warmgangmodul (20a-20f) für eine IT- oder Computereinrichtung nach einem der Ansprüche 1 bis 5, umfassend ferner an den teleskopierbaren Beinen (24a-24n) angebrachte Seitenarme (26a-26 l, 27a-27 l, 29a-29 l, 31a-31 l), vorzugsweise schwenkbar an den teleskopierbaren Beinen angebrachte Seitenarme, wobei die Seitenarme (26a-26 l, 27a-27 l, 29a-29 l, 31a-31 l) eine erste Position haben, in der die Seitenarme nicht aus der Rinne (22) herausragen, vorzugsweise sind die Seitenarme in der ersten Position im Wesentlichen parallel zu den teleskopierbaren Beinen, und eine zweite Position, in der die Seitenarme (26a-26 l, 27a-27 l, 29a-29 l, 31a-31 l) von der Rinne (22) vorstehen, vorzugsweise sind die Seitenarme in der zweiten Position in einem anderen Winkel als 0° oder 180° mit den teleskopierbaren Beinen (24a-24n), mehr bevorzugt sind die Seitenarme in der zweiten Position im Wesentlichen senkrecht zu den teleskopierbaren Beinen.

7. Warmgangmodul (20a-20f) für eine IT- oder Computereinrichtung nach Anspruch 6, wobei die Seitenarme (26a-26 l, 27a-27 l, 29a-29 l, 31a-31 l) so ausgelegt sind, dass sie in der zweiten Position Kabelträger, Stromschienen und andere Servicegegenstände tragen.

8. Warmgang- Einhausungssystem (48) für eine IT- oder Computereinrichtung mit beabstandeten Warmgängen, umfassend:
eine Mehrzahl von Warmgangmodulen (20a-20f) nach einem der Ansprüche 1 bis 7, die in den Warmgängen der IT- oder Computereinrichtung angeordnet sind; und Stützelemente (50), die sich zwischen benachbarten der Vielzahl von Warmgangmodulen erstrecken und mit diesen verbunden sind, vorzugsweise Träger (50), die an ihren Enden an den teleskopierbaren Beinen (24a-24n) der benachbarten der Vielzahl von beabstandeten Warmgangmodulen befestigt sind, wobei die benachbarten der Vielzahl von Warmgangmodulen vorzugsweise im Wesentlichen parallel sind.

9. Warmgang-Einhausungssystem (48) für eine IT- oder Computereinrichtung mit beabstandeten Warmgängen nach Anspruch 8, wobei jedes der mehreren Warmgangmodule (20a-20f) ferner Seitenarme (26a-26 l, 27a-27 l, 29a-29 l, 31a-31 l) umfasst, die an den teleskopierbaren Beinen (24a-24n) befestigt sind, vorzugsweise schwenkbar an den teleskopierbaren Beinen befestigt sind, wobei die Seitenarme eine erste Position haben, in der die Seitenarme nicht aus der Rinne (22) herausragen, und eine zweite Position, in der die Seitenarme aus der Rinne (22) herausragen.

10. Ein Datenzentrum (100), umfassend:
beabstandete Reihen (104a-104e) von IT-Racks und/oder Schränken Kaltgänge (107a-107c) und Warmgänge (108a-108c) zwischen den beabstandeten Reihen von IT-Racks und/oder Schränken, wobei die Kaltgänge (107a-107c) und die Warmgänge (108a-108c) zwischen den beabstandeten Reihen (104a-104e) von IT-Racks und/oder Schränken abwechseln;
ein Warmgang-Einhausungssystem (48), das Folgendes umfasst:
das Warmgangmodul (20a-20f) nach einem der Ansprüche 1 bis 7 in zwei oder mehr der Warmgänge (108a-108c); wobei die Rinnen (22) vorzugsweise Luft aus den Warmgängen (108a-108c) zu einem Luftabzugssystem des Datenzentrums (100) leiten; und
wobei die Unterseite der Rinnen der Warmgangmodule oberhalb der Oberseite der Reihen von IT-Racks und/oder Schränken, die den Warmgang bilden, positioniert sind; und
Stützelemente (50), die sich zwischen den Warmgangmodulen in benachbarten Warmgängen erstrecken und mit diesen verbunden sind, vorzugsweise Träger, die an ihren Enden an den teleskopierbaren Beinen (24a-24n) der Warmgangmodule in den benachbarten Warmgängen befestigt sind.

11. Ein Kühlsystem für zwei Reihen von IT-Racks und/oder -Schränken, umfassend einen Warmgang zwischen den beiden Reihen von IT-Racks und/oder -Schränken, der aus den beiden Reihen von IT-Racks und/oder -Schränken austretende Warmluft aufnimmt; und
das Warmgangmodul (20a-20f) nach einem der Ansprüche 1 bis 7 in dem Warmgang; wobei sich die Rinne (22) vorzugsweise zwischen der Oberseite der beiden Reihen von IT-Racks und/oder Schränken und einem Luftabzugssystem erstreckt.

12. Verfahren zum Installieren eines Warmgang-Einhausungssystems (48) in einer IT- oder Computereinrichtung mit beabstandeten Reihen von IT-Racks und/oder Schränken und abwechselnden Warm- und Kaltgängen zwischen den beabstandeten Reihen von IT-Racks und/oder Schränken, umfassend die Schritte:
Transportieren von mindestens zwei Warmgangmodulen in die IT- oder ComputerEinrichtung, wobei jedes Warmgangmodul umfasst:
eine Rinne (22), die aus beabstandeten Seitenwänden (28, 30) und beabstandeten Endwänden (32, 34) gebildet ist, wobei die beabstandeten Seitenwände und die beabstandeten Endwände verbunden sind, um ein Luftdurchgangsgehäuse mit einer offenen Oberseite und einer offenen Unterseite zu bilden; und
teleskopierbare Beine (24a-24n) mit eingefahrenen und ausgefahrenen Positionen und mit unteren Enden, die so konfiguriert sind, dass sie auf einem Boden der IT- oder Computereinrichtung ruhen;
wobei die Rinne von den teleskopierbaren Beinen getragen wird;
wobei während mindestens eines Teils des Transportschritts die teleskopierbaren Beine in der eingefahrenen Position sind;
Positionieren der mindestens zwei Warmgangmodule (20a-20f) in mindestens zwei der Warmgänge der IT- oder Computereinrichtung;
Ausfahren der teleskopierbaren Beine (24a-24n) der mindestens zwei Warmgangmodule, bis die Böden der Rinnen (22) der mindestens zwei Warmgangmodule über den benachbarten Reihen von IT-Racks und/oder Schränken liegen; und
Verbinden der mindestens zwei Warmgangmodule mit Stützelementen (50), die sich zwischen den mindestens zwei Warmgangmodulen erstrecken und mit diesen verbunden sind.

13. Verfahren zum Installieren eines Warmgang-Einhausungssystems in einer IT- oder Computereinrichtung mit beabstandeten Reihen von IT-Racks und/oder -Schränken und abwechselnden Warm- und Kaltgängen zwischen den beabstandeten Reihen von IT-Racks und/oder -Schränken gemäss Anspruch 12, wobei jedes Warmgangmodul (20a-20f) Seitenarme (26a-26 l, 27a-27 l, 29a-29 l, 31a-31 l) umfasst, die an den teleskopierbaren Beinen (24a-24n) angebracht sind, wobei die Seitenarme eine erste Position, in der die Seitenarme nicht aus der Rinne herausragen, und eine zweite Position, in der die Seitenarme aus der Rinne herausragen, aufweisen; und das Verfahren ferner den Schritt des Bewegens der Seitenarme von der ersten Position in die zweite Position nach dem Schritt des Ausfahrens der teleskopierbaren Beine umfasst.

## Revendications

1. Module d'allée chaude (20a-20f) pour une installation informatique ou un centre informatique comprenant: une goulotte (22) formant une enceinte de passage d'air avec un haut ouvert et un bas ouvert; et des pieds (24a-24n) avec des extrémités inférieures configurées pour reposer sur un sol de l'installation informatique ou du centre informatique; dans lequel la goulotte (22) est supportée par les pieds (24a-24n); **caractérisé en ce que** les pieds sont télescopiques, et **en ce que** la hauteur de la goulotte (22) peut être ajustée dans une allée chaude de l'installation informatique ou du centre informatique en télescopant les pieds télescopiques (24a-24n) pour diriger l'air chaud de l'allée chaude vers un système d'évacuation de l'installation informatique ou du centre informatique.

2. Module d'allée chaude (20a-20f) pour une installation informatique ou un centre informatique selon la revendication 1, dans lequel la goulotte (22) est formée par des parois latérales espacées (28, 30) et des parois d'extrémité espacées (32, 34) qui sont reliées à leurs extrémités pour former une boîte à extrémités ouvertes.

3. Module d'allée chaude (20a-20f) pour une installation informatique ou un centre informatique selon la revendication 2, dans lequel les pieds télescopiques (24a-24n) sont espacés le long des parois latérales (28, 30) de la goulotte (22) et les parois latérales comprennent des panneaux (28a-28k, 30a-30k) qui sont supportés et retenus par les pieds télescopiques.

4. Module d'allée chaude (20a-20f) pour une installation informatique ou un centre informatique selon la revendication 2 ou 3, dans lequel: les parois latérales espacées (28, 30) sont des première et seconde parois latérales qui sont sensiblement parallèles et les parois d'extrémité espacées (32, 34) sont des première et seconde parois d'extrémité qui sont sensiblement parallèles; et chacune des première et seconde parois d'extrémité est connectée sur ses extrémités aux première et seconde parois latérales.

5. Module d'allée chaude (20a-20f) pour une installation informatique ou un centre informatique selon la revendication 4, dans lequel la goulotte (22) comprend en outre des éléments de support transversaux (50) qui s'étendent entre les première et seconde parois latérales et sont fixés à leurs extrémités aux première et seconde parois latérales.

6. Module d'allée chaude (20a-20f) pour une installation informatique ou un centre informatique selon l'une quelconque des revendications 1 à 5, comprenant en outre des bras latéraux (26a-26l, 27a-27l, 29a-291, 31a-311) fixés aux pieds télescopiques (24a-24n), de préférence fixés de manière pivotante aux pieds télescopiques, les bras latéraux (26a-26l, 27a-27l, 29a-29l, 31a-31l) ayant une première position dans laquelle les bras latéraux ne font pas saillie de la goulotte (22), de préférence les bras latéraux étant sensiblement parallèles aux pieds télescopiques dans la première position, et une seconde position dans laquelle les bras latéraux (26a-26l, 27a-27l, 29a-291, 31a-31l) font saillie de la goulotte (22), de préférence les bras latéraux étant à un angle autre que 0° ou 180° avec les pieds télescopiques (24a-24n) dans la seconde position, plus préférablement les bras latéraux étant sensiblement perpendiculaires aux pieds télescopiques dans la seconde position.

7. Module d'allée chaude (20a-20f) pour une installation informatique ou un centre informatique selon la revendication 6, dans lequel les bras latéraux (26a-26l, 27a-27l, 29a-291, 31a-311) sont conçus pour supporter des chemins de câbles, des barres bus et d'autres articles de service lorsqu'ils sont dans la seconde position.

8. Système de confinement d'allée chaude (48) pour une installation informatique ou un centre informatique ayant des allées chaudes espacées, comprenant: une pluralité de modules d'allées chaudes (20a-20f) selon l'une quelconque des revendications 1 à 7 situés dans les allées chaudes de l'installation informatique ou du centre informatique; et des éléments de support (50) qui s'étendent entre et sont reliés à des modules adjacents de la pluralité de modules d'allées chaudes, de préférence des poutres (50) fixées à leurs extrémités aux pieds télescopiques (24a-24n) des modules adjacents de la pluralité de modules d'allées chaudes espacés, lesdits modules adjacents de la pluralité de modules d'allées chaudes étant de préférence sensiblement parallèles.

9. Système de confinement d'allée chaude (48) pour une installation informatique ou un centre informatique ayant des allées chaudes espacées selon la revendication 8, dans lequel chacun de la pluralité de modules d'allée chaude (20a-20f) comprend en outre des bras latéraux (26a-26l, 27a-27l, 29a-29l, 31a-31 l) fixés aux pieds télescopiques (24a-24n), de préférence fixés de manière pivotante aux pieds télescopiques, les bras latéraux ayant une première position dans laquelle les bras latéraux ne font pas saillie de la goulotte (22) et une seconde position dans laquelle les bras latéraux font saillie de la goulotte (22).

10. Centre de données (100) comprenant: des rangées espacées (104a-104e) de racks et/ou d'armoires informatiques; des allées froides (107a-107c) et des allées chaudes (108a-108c) entre les rangées espacées de racks et/ou d'armoires informatiques, les allées froides (107a-107c) et les allées chaudes (108a-108c) alternant entre les rangées espacées (104a-104e) de racks et/ou d'armoires informatiques; un système de confinement d'allée chaude (48) comprenant: le module d'allée chaude (20a-20f) selon l'une quelconque des revendications 1 à 7 dans deux ou plusieurs des allées chaudes (108a-108c); dans lequel les goulottes (22) dirigent de préférence l'air des allées chaudes (108a-108c) vers un système d'évacuation d'air du centre de données (100); et dans lequel le bas des goulottes des modules d'allée chaude est positionné au-dessus du haut des rangées de racks et/ou d'armoires informatiques formant l'allée chaude; et des éléments de support (50) qui s'étendent entre et sont connectés aux modules d'allée chaude dans des allées chaudes adjacentes, de préférence des poutres fixées à leurs extrémités aux pieds télescopiques (24a-24n) des modules d'allée chaude dans les allées chaudes adjacentes.

11. Système de refroidissement pour deux rangées de racks et/ou d'armoires informatiques comprenant: une allée chaude entre les deux rangées de racks et/ou d'armoires informatiques qui reçoit de l'air chaud sortant des deux rangées de racks et/ou d'armoires informatiques; et le module d'allée chaude (20a-20f) selon l'une quelconque des revendications 1 à 7 dans l'allée chaude; dans lequel la goulotte (22) s'étend de préférence entre le haut des deux rangées de racks et/ou d'armoires informatiques et un système d'évacuation d'air.

12. Procédé d'installation d'un système de confinement d'allée chaude (48) dans une installation informatique ou un centre informatique ayant des rangées espacées de racks et/ou d'armoires informatiques et des allées chaudes et froides alternées entre les rangées espacées de racks et/ou d'armoires informatiques, comprenant les étapes consistant à: transporter au moins deux modules d'allée chaude dans l'installation informatique ou le centre informatique, chaque module d'allée chaude comprenant: une goulotte (22) formée de parois latérales espacées (28, 30) et de parois d'extrémité espacées (32, 34), les parois latérales espacées et les parois d'extrémité espacées étant reliées pour former une enceinte de passage d'air avec un haut ouvert et un bas ouvert; et des pieds télescopiques (24a-24n) ayant des positions rétractées et étendues et avec des extrémités inférieures configurées pour reposer sur un sol de l'installation informatique ou du centre informatique; dans laquelle la goulotte est supportée par les pieds télescopiques; dans laquelle pendant au moins une partie de l'étape de transport, les pieds télescopiques sont dans la position rétractée; positionner les au moins deux modules d'allées chaudes (20a-20f) dans au moins deux des allées chaudes de l'installation informatique ou du centre informatique; étendre les pieds télescopiques (24a-24n) des au moins deux modules d'allées chaudes jusqu'à ce que les fonds des goulottes (22) des au moins deux modules d'allées chaudes soient au-dessus des rangées adjacentes de racks et/ou d'armoires informatiques; et connecter les au moins deux modules d'allées chaudes avec des éléments de support (50) qui s'étendent entre et sont connectés aux au moins deux modules d'allées chaudes.

13. Procédé d'installation d'un système de confinement d'allée chaude dans une installation informatique ou un centre informatique ayant des rangées espacées de racks et/ou d'armoires informatiques et des allées chaudes et froides alternées entre les rangées espacées de racks et/ou d'armoires informatiques selon la revendication 12, dans lequel chaque module d'allée chaude (20a-20f) comprend des bras latéraux (26a-26l, 27a-27l, 29a-29l, 31a-31l) fixés aux pieds télescopiques (24a-24n), les bras latéraux ayant une première position dans laquelle les bras latéraux ne dépassent pas de la goulotte et une seconde position dans laquelle les bras latéraux dépassent de la goulotte; et le procédé comprend en outre l'étape consistant à déplacer les bras latéraux de la première position à la seconde position après l'étape consistant à étendre les pieds télescopiques.
